# EUROPEAN PATENT APPLICATION

(11) **EP 3 264 788 A1**
(43) Date of publication of application: **03.01.2018**
(21) Application number: 16754984.9
(22) Date of filing: 22.02.2016
(51) Int. Cl.: H04R 1/00, H04M 1/02, H04R 1/02, H05K 5/06

(54) **WATERPROOF SOUND-TRANSMITTING STRUCTURE AND ELECTRONIC DEVICE AND ELECTRONIC DEVICE CASE COMPRISING SAME**

(30) Priority: 26.02.2015 JP 2015036712
(71) Applicant: Nitto Denko Corporation, Ibaraki-shi, Osaka 567-8680 (JP)
(72) Inventor: HIRAI, Bunta, Ibaraki-shi Osaka 567-8680 (JP); FURUYAMA, Satoru, Ibaraki-shi Osaka 567-8680 (JP); MORI, Masaaki, Ibaraki-shi Osaka 567-8680 (JP); YAMAMOTO, Hajime, Ibaraki-shi Osaka 567-8680 (JP)
(74) Representative: Müller-Boré & Partner Patentanwälte PartG mbB
(86) International application number: PCT/JP2016/000936
(87) International publication number: WO 2016/136233

(57) **Abstract**

A waterproof sound transmission structure of the present disclosure includes: a wall separating a first space from a second space where water can be present, the wall being provided with a sound transmission port for transmission of sound between the first and second spaces; and a waterproof sound-permeable membrane placed to cover the sound transmission port, the waterproof sound-permeable membrane being adapted to permit transmission of sound between the first and second spaces and being further adapted to prevent ingress of water from the second space into the first space through the sound transmission port. The first space is sealed when the second space is filled with water, the sealed first space having a volume of 300 mm³ or less. The waterproof sound-permeable membrane includes: a non-porous resin film having through holes formed to extend through the thickness of the resin film; and a liquid-repellent layer formed on a principal surface of the resin film and having openings positioned in correspondence with the through holes. The through holes have a diameter of 5.0 µm or more and 13.0 µm or less. The waterproof sound transmission structure of the present disclosure has higher levels of both waterproofness and sound permeability than conventional waterproof sound transmission structures.

## Description

### TECHNICAL FIELD

The present invention relates to a waterproof sound transmission structure having both waterproofness and sound permeability and to an electronic device and electronic device case that include the structure.

### BACKGROUND ART

Nowadays, it is typical for electronic devices such as mobile phones, tablet computers, digital cameras, and game consoles to have an audio function. In the housing of such an electronic device having an audio function, an audio component such as a speaker and/or a microphone is placed as an audio part (specifically a sound emitter and/or a sound receiver). The housing of the electronic device typically has a sound transmission port positioned in correspondence with the audio part. This sound transmission port allows sound to be transmitted between the outside of the electronic device and the audio part.

Naturally, ingress of water into the housing of an electronic device must be prevented; however, the above sound transmission port for transmission of sound may act as a passage that permits water to easily enter the housing. In particular, portable electronic devices have an increased risk of suffering from ingress of water because they are often exposed to rain or water used in daily life and because the orientation of the opening of the sound transmission port cannot be fixed at a given orientation that allows the avoidance of water (for example, a downward orientation for which rain is less likely to come into the housing). For this reason, a waterproof sound-permeable membrane permeable to sound but impervious to water is placed to cover the sound transmission port so that the housing has a waterproof sound transmission structure. The waterproof sound transmission structure allows transmission of sound between the audio part and the outside of the housing while preventing water from entering the housing from the outside through the sound transmission port. The waterproof sound transmission structure is applicable not only to a housing of an electronic device but also to any part required to ensure both sound permeability through a sound transmission port and waterproofness at the sound transmission port.

An exemplary waterproof sound-permeable membrane is a non-porous resin film having through holes formed to extend through the thickness of the film (see Patent Literature 1). The waterproof sound-permeable membrane of Patent Literature 1 is formed by irradiating a non-porous resin film with an ion beam and then chemically etching the irradiated film.

### CITATION LIST

### Patent Literature

Patent Literature 1: JP 2012-195928 A

### SUMMARY OF INVENTION

### Technical Problem

An object of the present invention is to provide: a waterproof sound transmission structure having higher levels of both waterproofness and sound permeability than conventional waterproof sound transmission structures; and an electronic device and electronic device case that include the structure.

### Solution to Problem

A waterproof sound transmission structure of the present disclosure is a waterproof sound transmission structure including: a wall separating a first space from a second space where water can be present, the wall being provided with a sound transmission port for transmission of sound between the first and second spaces; and a waterproof sound-permeable membrane placed to cover the sound transmission port, the waterproof sound-permeable membrane being adapted to permit transmission of sound between the first and second spaces and being further adapted to prevent ingress of water from the second space into the first space through the sound transmission port. The first space is sealed when the second space is filled with water, the sealed first space having a volume of 300 mm³ or less. The waterproof sound-permeable membrane includes: a non-porous resin film having through holes formed to extend through the thickness of the resin film; and a liquid-repellent layer formed on a principal surface of the resin film and having openings positioned in correspondence with the through holes, the through holes having a diameter of 5.0 µm or more and 13.0 µm or less.

An electronic device of the present disclosure is an electronic device having an audio part, the electronic device including the above waterproof sound transmission structure of the present disclosure. In the waterproof sound transmission structure, the wall is a housing of the electronic device, the second space is a space located outside the housing, the first space is a space located inside the housing and containing the audio part, and the sound transmission port is a sound transmission port for transmission of sound from and/or to the audio part.

An electronic device case of the present disclosure is an electronic device case for enclosing an electronic device having an audio part, the electronic device case including the above waterproof sound transmission structure of the present disclosure. In the waterproof sound transmission structure, the wall is a housing of the case, the second space is a space located outside the housing, the first space is a space located inside the housing for enclosing the electronic device, and the sound transmission port is a sound transmission port for transmission of sound from and/or to the audio part of the electronic device enclosed in the case.

### Advantageous Effects of Invention

The present invention makes it possible to attain: a waterproof sound transmission structure having higher levels of both waterproofness and sound permeability than conventional waterproof sound transmission structures; and an electronic device and electronic device case that include the structure.

### BRIEF DESCRIPTION OF DRAWINGS

FIG. 1 is a cross-sectional view schematically showing an example of the waterproof sound transmission structure of the present invention.
FIG. 2 is a cross-sectional view schematically showing the state of the waterproof sound-permeable membrane when the second space is filled with water in the waterproof sound transmission structure shown in FIG. 1.
FIG. 3 is a cross-sectional view schematically showing an example of the waterproof sound-permeable membrane included in the waterproof sound transmission structure of the present invention.
FIG. 4 is a cross-sectional view schematically showing another example of the waterproof sound-permeable membrane included in the waterproof sound transmission structure of the present invention.
FIG. 5 is a plan view schematically showing an example of the relationship among the through holes of the waterproof sound-permeable membrane included in the waterproof sound transmission structure of the present invention in terms of the directions in which the through holes extend.
FIG. 6 is a plan view schematically showing another example of the relationship among the through holes of the waterproof sound-permeable membrane included in the waterproof sound transmission structure of the present invention in terms of the directions in which the through holes extend.
FIG. 7 is a cross-sectional view schematically showing still another example of the relationship among the through holes of the waterproof sound-permeable membrane included in the waterproof sound transmission structure of the present invention in terms of the directions in which the through holes extend.
FIG. 8 is a cross-sectional view schematically showing still another example of the waterproof sound-permeable membrane included in the waterproof sound transmission structure of the present invention.
FIG. 9 is a cross-sectional view schematically showing still another example of the waterproof sound-permeable membrane included in the waterproof sound transmission structure of the present invention.
FIG. 10 is a schematic diagram for illustrating the overview of ion beam irradiation in a method for forming a resin film of the waterproof sound-permeable membrane included in the waterproof sound transmission structure of the present invention by employing the ion beam irradiation and the subsequent chemical etching.
FIG. 11 is a schematic diagram for illustrating an example of the ion beam irradiation in a method for forming a resin film of the waterproof sound-permeable membrane included in the waterproof sound transmission structure of the present invention by employing the ion beam irradiation and the subsequent chemical etching.
FIG. 12 is a perspective view schematically showing an example of the waterproof sound-permeable membrane (a waterproof sound-permeable member including a supporting member) included in the waterproof sound transmission structure of the present invention.
FIG. 13 is a plan view schematically showing another example of the waterproof sound-permeable membrane (a waterproof sound-permeable member including a supporting member) included in the waterproof sound transmission structure of the present invention.
FIG. 14A is a perspective view schematically showing an example of the electronic device of the present invention.
FIG. 14B is a cross-sectional view schematically showing an example of how the waterproof sound-permeable membrane is placed in the electronic device shown in FIG. 14A.
FIG. 15A is a perspective view schematically showing another example of the electronic device of the present invention.
FIG. 15B is a cross-sectional view schematically showing an example of how the waterproof sound-permeable membrane is placed in the electronic device shown in FIG. 15A.
FIG. 16A is a perspective view schematically showing an example of the electronic device case of the present invention.
FIG. 16B is a cross-sectional view schematically showing an example of how the waterproof sound-permeable membrane is placed in the electronic device case shown in FIG. 16A.
FIG. 17A is a cross-sectional view schematically showing: a simulated housing used for evaluation of sound pressure loss (insertion loss) caused by waterproof sound-permeable membranes in Examples; and how a speaker is placed in the housing.
FIG. 17B is a cross-sectional view schematically showing: a member prepared for evaluation of sound pressure loss (insertion loss) caused by waterproof sound-permeable membranes in Examples; and a state where the member is attached to a simulated housing.
FIG. 18A is a view for illustrating a method employed for evaluation of the waterproofness of waterproof sound transmission structures in Examples.
FIG. 18B is a view for illustrating a method employed for evaluation of the waterproofness of waterproof sound transmission structures in Examples.

### DESCRIPTION OF EMBODIMENTS

The first aspect of the present disclosure provides a waterproof sound transmission structure including:
a wall separating a first space from a second space where water can be present, the wall being provided with a sound transmission port for transmission of sound between the first and second spaces; and
a waterproof sound-permeable membrane placed to cover the sound transmission port, the waterproof sound-permeable membrane being adapted to permit transmission of sound between the first and second spaces and being further adapted to prevent ingress of water from the second space into the first space through the sound transmission port, wherein
the first space is sealed when the second space is filled with water, the sealed first space having a volume of 300 mm³ or less, and
the waterproof sound-permeable membrane includes:
   a non-porous resin film having through holes formed to extend through the thickness of the resin film; and
   a liquid-repellent layer formed on a principal surface of the resin film and having openings positioned in correspondence with the through holes,
   the through holes having a diameter of 5.0 µm or more and 13.0 µm or less.

The second aspect of the present disclosure provides the waterproof sound transmission structure as set forth in the first aspect, wherein a water entry pressure of the waterproof sound transmission structure is greater than a water entry pressure of the waterproof sound-permeable membrane placed to cover the sound transmission port, the water entry pressure of the waterproof sound-permeable membrane being measured according to Method B (high hydraulic pressure method) of water penetration test specified in JIS L 1092.

The third aspect of the present disclosure provides the waterproof sound transmission structure as set forth in the first or second aspect, being compliant with IPX7 specified as a degree of protection against water ingress in JIS C 0920.

The fourth aspect of the present disclosure provides the waterproof sound transmission structure as set forth in the third aspect, wherein the water entry pressure of the waterproof sound-permeable membrane is 3.0 kPa or more and less than 9.8 kPa, and the volume is 10 mm³ or less.

The fifth aspect of the present disclosure provides the waterproof sound transmission structure as set forth in the third aspect, wherein the water entry pressure of the waterproof sound-permeable membrane is 2.0 kPa or more and less than 3.0 kPa, and the volume is 5 mm³ or less.

The sixth aspect of the present disclosure provides the waterproof sound transmission structure as set forth in any one of the first to fifth aspects, wherein an effective area of the waterproof sound-permeable membrane is 4.9 mm² or less.

The seventh aspect of the present disclosure provides the waterproof sound transmission structure as set forth in any one of the first to sixth aspects, wherein the waterproof sound-permeable membrane has an air permeability in a thickness direction of the waterproof sound-permeable membrane, the air permeability being 2.0 cm³/(cm²•sec) or more and 120 cm³/(cm²•sec) or less as expressed in terms of Frazier number measured according to JIS L 1096.

The eighth aspect of the present disclosure provides the waterproof sound transmission structure as set forth in any one of the first to seventh aspects, wherein an insertion loss in a frequency range of 100 Hz to 5 kHz is 2 dB or less.

The ninth aspect of the present disclosure provides the waterproof sound transmission structure as set forth in any one of the first to eighth aspects, wherein the waterproof sound-permeable membrane is subjected to a coloring treatment that enables the waterproof sound-permeable membrane to absorb light in a wavelength range of 380 nm to 500 nm.

The tenth aspect of the present disclosure provides the waterproof sound transmission structure as set forth in any one of the first to eighth aspects, wherein the waterproof sound-permeable membrane is colored black, gray, brown, or pink.

The eleventh aspect of the present disclosure provides an electronic device having an audio part, the electronic device including the waterproof sound transmission structure according to any one of the first to tenth aspects, wherein in the waterproof sound transmission structure, the wall is a housing of the electronic device, the second space is a space located outside the housing, the first space is a space located inside the housing and containing the audio part, and the sound transmission port is a sound transmission port for transmission of sound from and/or to the audio part.

The twelfth aspect of the present disclosure provides an electronic device case for enclosing an electronic device having an audio part, the electronic device case including the waterproof sound transmission structure according to any one of the first to tenth aspects, wherein in the waterproof sound transmission structure, the wall is a housing of the case, the second space is a space located outside the housing, the first space is a space located inside the housing for enclosing the electronic device, and the sound transmission port is a sound transmission port for transmission of sound from and/or to the audio part of the electronic device enclosed in the case.

### [Waterproof sound transmission structure]

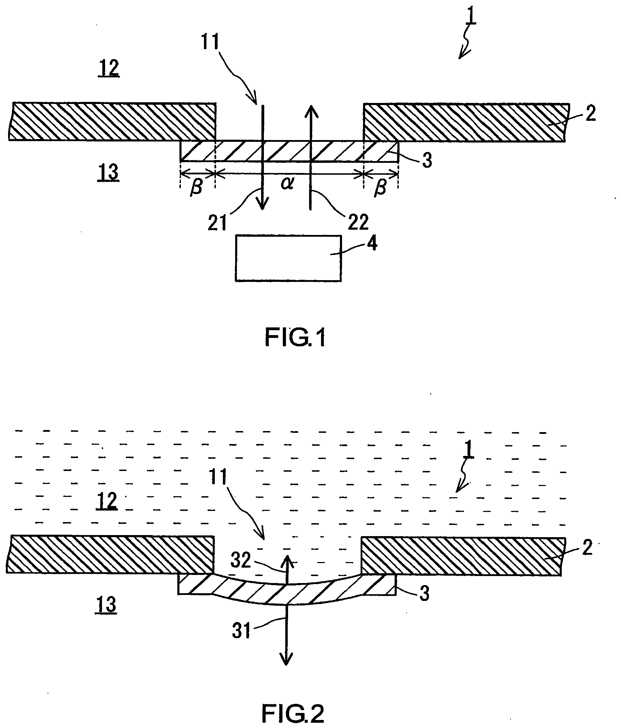

FIG. 1 shows an example of the waterproof sound transmission structure of the present invention. The waterproof sound transmission structure 1 shown in FIG. 1 includes: a wall 2 provided with a sound transmission port 11; and a waterproof sound-permeable membrane 3 placed to cover the sound transmission port 11. The waterproof sound-permeable membrane 3 is a membrane permeable to sound but impervious to water. The wall 2 separates two spaces 12 and 13 from each other, and the sound transmission port 11 is an opening portion for transmission of sound between these two spaces. In one of the spaces, the space 12 (second space), there can be present water. Water may be present also in the other space 13 (first space); however, the space 13 is typically a space in which water is not or should not be present, such as the internal space of the housing of an electronic device. The term "water" as used herein refers to liquid water, unless otherwise specified.

The wall 2 prevents transfer of water between the two spaces 12 and 13 and also limits transmission of sound between the spaces 12 and 13. In the waterproof sound transmission structure 1, sound 21 and 22 can be transmitted between the spaces 12 and 13 through the sound transmission port 11 formed in the wall 2 and the waterproof sound-permeable membrane 3 placed over the sound transmission port 11. The waterproof sound-permeable membrane 3 can prevent ingress of water into the first space 13 from the second space 12 where water can be present. When an audio part 4 that emits and/or receives sound is disposed in the space 13 as in the example shown in FIG. 1 (when the first space 13 contains the audio part 4), the sound 21 is transmitted to the audio part 4 from the space 12, while the sound 22 is emitted from the audio part 4 and transmitted to the space 12.

The first space 13 in the waterproof sound transmission structure 1 is sealed when the second space 12 is filled with water, the sealed first space 13 having a volume of 300 mm³ or less. When the space 12 is filled with water, a water pressure 31 is applied to the waterproof sound-permeable membrane 3 so that the membrane 3 is deformed, specifically bowed, toward the first space 13 (see FIG. 2). The deformation of the membrane 3 correspondingly reduces the volume of the first space 13 which is a sealed space, resulting in an increase in the internal pressure of the space 13. This increase in internal pressure produces a pressure 32 acting on the waterproof sound-permeable membrane 3 in the direction from the first space 13 to the second space 12, and the pressure 32 cancels out some of the water pressure 31. Assuming that the volume of the sealed space is varied while the water pressure 31 applied to the membrane 3, and therefore the amount of the deformation of the membrane 3 caused by the water pressure 31, are kept constant, the smaller the volume of the sealed space is, the greater the increase in internal pressure and the degree of cancellation of the water pressure 31 are, and thus the smaller the water pressure substantially applied to the waterproof sound-permeable membrane 3 is. The waterproof sound-permeable membrane 3 has waterproofness inherent to itself (inherent waterproofness) which depends on its configuration. Even with the use of the waterproof sound-permeable membrane 3 having inherent waterproofness lower than the waterproofness required of the waterproof sound transmission structure 1, the structure 1 can be formed as a waterproof sound transmission structure having the required waterproofness since the water pressure substantially applied to the membrane 3 is reduced as described above. The sound permeability of a waterproof sound-permeable membrane (the properties of sound transmitted through the waterproof sound-permeable membrane) becomes poorer as the inherent waterproofness of the membrane increases. That is, there is a trade-off relationship between the waterproofness and sound permeability of the waterproof sound-permeable membrane 3. The waterproof sound transmission structure 1, which can achieve required waterproofness with the use of a waterproof sound-permeable membrane having inherent waterproofness lower than the required waterproofness, can have higher levels of both waterproofness and sound permeability than conventional waterproof sound transmission structures.

The volume of the first space 13 sealed when the second space 12 is filled with water, namely, the volume of the first space 13 in the sealed state (sealed-state volume) is 300 mm³ or less. If this volume is more than 300 mm³, the degree of cancellation of the water pressure 31 applied to the waterproof sound-permeable membrane 3 is insufficient so that waterproofness and sound permeability cannot be achieved at higher levels than ever before.

The waterproof sound-permeable membrane 3 included in the waterproof sound transmission structure 1 includes: a non-porous resin film having through holes formed to extend through the thickness of the resin film; and a liquid-repellent layer formed on a principal surface of the resin film and having openings positioned in correspondence with the through holes. The waterproofness and sound permeability of such a waterproof sound-permeable membrane 3 can be controlled by adjusting the diameter of the through holes, which means that the control of waterproofness and sound permeability can be accomplished with high flexibility. This contributes to achieving high levels of both waterproofness and sound permeability of the waterproof sound transmission structure 1. In addition, since the waterproof sound-permeable membrane 3 employs a non-porous resin film as its base (original material), the membrane 3 is highly uniform in mechanical properties such as strength and can be formed as a waterproof sound-permeable membrane that has through holes with uniform diameters and/or in which the through holes are uniformly distributed. Thus, penetration of water due to non-uniformity of the membrane can be prevented, and the effect of cancelling out the water pressure 31, which is shown in FIG. 2, can be satisfactorily obtained. This also contributes to achieving high levels of both waterproofness and sound permeability of the waterproof sound transmission structure 1. The waterproof sound-permeable membrane 3 having a configuration as described above intrinsically has high sound permeability. The high sound permeability is evidently reflected, in particular, in a low insertion loss in the frequency range of 100 Hz to 5 kHz. The lowness of the insertion loss in this frequency range is important for waterproof sound transmission structures.

The diameter of the through holes in the waterproof sound-permeable membrane 3 is 5.0 µm or more and 13.0 µm or less. If the diameter of the through holes is more than 13.0 µm, the inherent waterproofness of the membrane 3 is low, so that it is difficult to achieve high levels of both waterproofness and sound permeability of the waterproof sound transmission structure 1. If the diameter of the through holes is less than 5 µm, the sound permeability of the waterproof sound transmission structure 1 tends to decrease, although the structure can, due to the very high inherent waterproofness of the membrane 3, have sufficient waterproofness even when the sealed-state volume is equal to or larger than a certain value.

The sealed-state volume of the first space 13 is preferably 200 mm³ or less, more preferably 150 mm³ or less, and even more preferably 100 mm³ or less, although this depends on the level of waterproofness required of the waterproof sound transmission structure 1. A reduction in the sealed-state volume of the first space 13 allows an increase in the extent to which the inherent waterproofness of the waterproof sound-permeable membrane 3 to be used is lower than the waterproofness required of the waterproof sound transmission structure 1, thereby leading to increase in the achieved levels of both waterproofness and sound permeability of the waterproof sound transmission structure 1. The sealed-state volume of the first space 13 can be further reduced and may be, for example, 50 mm³ or less, 30 mm³ or less, 10 mm³ or less, or even 5 mm³ or less.

The sealed-state volume of the first space 13 refers to the volume occupied by air present in the space and communicable with the waterproof sound-permeable membrane 3 and sound transmission port 11, and does not include the volume of any product lying in the space. This is because the volume of a product in the space is not responsible for the generation of the pressure 32 due to the deformation of the waterproof sound-permeable membrane 3. The sealed-state volume of the first space 13 corresponds to the volume when the second space 12 is not filled with water (when the waterproof sound-permeable membrane 3 is not deformed by the water pressure 31).

A typical measure of the waterproofness is a water entry pressure. A water entry pressure of the waterproof sound transmission structure 1 can be higher than a water entry pressure (inherent water entry pressure) of the waterproof sound-permeable membrane 3 placed to cover the sound transmission port 11, the water entry pressure of the waterproof sound-permeable membrane 3 being measured according to Method B (high hydraulic pressure method) of water penetration test specified in JIS L 1092.

The waterproofness of the waterproof sound transmission structure can be evaluated also by the degrees of protection against water ingress which are specified in JIS C 0920. Among these degrees of protection, the degree of protection "IPX7" is essentially relevant to the situation where the second space 12 is filled with water. When the waterproof sound transmission structure 1 is compliant with IPX7, the water entry pressure as measured for the structure 1 according to the Method B of water penetration test is estimated to be 9.8 kPa or more on the basis of the principle of the IPX7 testing which evaluates whether water enters the inside of a waterproof structure when the structure is immersed in water at a depth of 1 m.

The waterproof sound transmission structure 1 can be compliant with IPX7 specified as a degree of protection against water ingress in JIS C 0920. An electronic device having the waterproof sound transmission structure 1 compliant with IPX7 can avoid ingress of water into the device even when accidentally dropped into water, insofar as the water depth and the duration of submergence are at or below given limits.

For the waterproof sound transmission structure 1, for example, the relationships as specified below can be established between the sealed-state volume of the first space 13 and the inherent water entry pressure of the waterproof sound-permeable membrane 3. That is, an example of the relationships established when the waterproof sound transmission structure 1 is compliant with IPX7 is one in which the water entry pressure of the waterproof sound-permeable membrane 3 as measured according to the Method B of water penetration test is 3.0 kPa or more and less than 9.8 kPa while the sealed-state volume of the first space 13 is 10 mm³ or less. Another exemplary relationship is one in which the water entry pressure of the waterproof sound-permeable membrane 3 as measured according to the Method B of water penetration test is 2.0 kPa or more and less than 3.0 kPa while the sealed-state volume of the first space 13 is 5 mm³ or less. It is evident that when these relationships are established, the water entry pressure of the waterproof sound transmission structure is higher than the inherent water entry pressure of the waterproof sound-permeable membrane placed to cover the sound transmission port of the structure.

The design of the first space 13 is not limited, as long as the space 13 is a sealed space when the second space 12 is filled with water. The waterproof sound-permeable membrane 3 is impervious to water, so that sealing of the space 13 at the sound transmission port 11 covered by the membrane 3 is maintained when the second space 12 in contact with the membrane 3 is filled with water. An exemplary situation where the second space 12 is filled with water is when the sound transmission port 11 of the waterproof sound transmission structure 1 is entirely submerged in water.

The first space 13 is, for example, a space surrounded by the wall 2 having no opening portion other than the sound transmission port 11. The first space 13 may be, for example, a space surrounded by the wall 2 having another opening portion in addition to the sound transmission port 11. In this case, a waterproof membrane is placed to cover the other opening portion so that sealing of the space is maintained also at the other opening portion when the second space 12 is filled with water. The waterproof membrane placed to cover the other opening portion may be the waterproof sound-permeable membrane 3 or may be another waterproof membrane (such as a waterproof air-permeable membrane or waterproof sound-permeable membrane). A known membrane may be used as the other waterproof membrane.

In one example, the first space 13 is a space located inside the housing of an electronic device provided with the waterproof sound transmission structure 1, and may be the internal space itself of the housing. In this example, the second space 12 is a space located outside the housing of the electronic device and opposite to the space 13 across the wall 2 and the sound transmission port 11. In another example, the first space 13 is a space located inside the housing of an audio component such as a speaker, microphone, or transducer which is provided with the waterproof sound transmission structure 1, and may be the internal space itself of the housing. In this case, the second space 12 is a space located outside the housing of the audio component and opposite to the space 13 across the wall 2 and the sound transmission port 11.

As can be understood from the above examples, there is no limitation to the wall 2 of the waterproof sound transmission structure 1. The waterproof sound transmission structure 1 is applicable to any location where both transmission of sound between the spaces 12 and 13 and prevention of penetration of water into the space 13 from the space 12 are required, as long as the spaces for formation and arrangement of the sound transmission port 11 and the waterproof sound-permeable membrane 3 covering the sound transmission port 11 can be obtained. Specific examples of the audio part 4 placed in the first space 13 therefore include a wide variety of audio parts. In the former of the above examples, the audio part 4 may be an audio component such as a speaker, microphone, or transducer enclosed in the housing of an electronic device. In the latter example, the audio part 4 may be an audio element such as a diaphragm enclosed in the housing of an audio component. As previously described, the sealed-state volume of the first space 13 refers to the volume occupied by air present in the space and communicable with the waterproof sound-permeable membrane 3 and sound transmission port 11, and does not include the volume of any product lying in the space. Thus, in the former example, the volumes of the components such as the audio component placed in the space 13 are not included in the sealed-state volume, while in the latter example, the volumes of the components such as the acoustic element placed in the space 13 are not included in the sealed-state volume.

The waterproof sound-permeable membrane 3 will now be described.

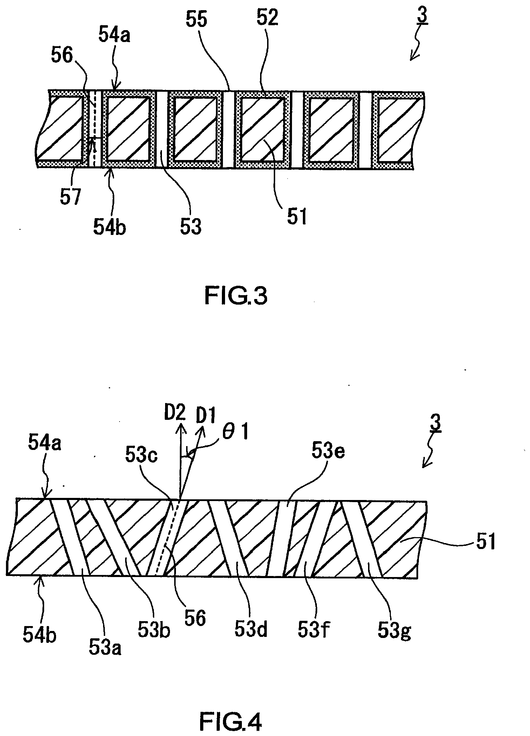

FIG. 3 shows an example of the waterproof sound-permeable membrane 3. The waterproof sound-permeable membrane 3 shown in FIG. 3 includes a resin film 51 and a liquid-repellent layer 52 formed on the principal surfaces of the resin film 51. The resin film 51 has through holes 53 formed to extend through the thickness of the resin film 51. The through holes 53 extend from a first principal surface 54a of the resin film 51 to a second principal surface 54b of the resin film 51. The liquid-repellent layer 52 has openings 55 positioned in correspondence with the through holes 53 of the resin film 51. The resin film 51 is a non-porous resin film and has no passages that allow through-thickness air permeation other than the through holes 53. The resin film 51 is typically an imperforate (solid) resin film having no holes other than the through holes 53. The through holes 53 have openings at both principal surfaces of the resin film 51.

The through holes 53 are straight holes having a central axis (axial line) 56 extending straight. The through holes 53 can be formed as straight holes, for example, by ion beam irradiation and subsequent chemical etching of an original film which is a resin film. With the combination of ion beam irradiation and etching, a large number of through holes 53 having more uniform diameters (opening diameters) can be formed in the resin film 51. The resin film 51 can be a film obtained by ion beam irradiation and etching of an original film. The high uniformity in diameter of the through holes 53 in the waterproof sound-permeable membrane 3 contributes to achieving high levels of both waterproofness and sound permeability of the waterproof sound transmission structure 1. In FIG. 3 and the subsequent figures illustrating the structure of a waterproof sound-permeable membrane, the diameters of through holes are exaggeratedly shown to make it easy to understand the shape of the through holes.

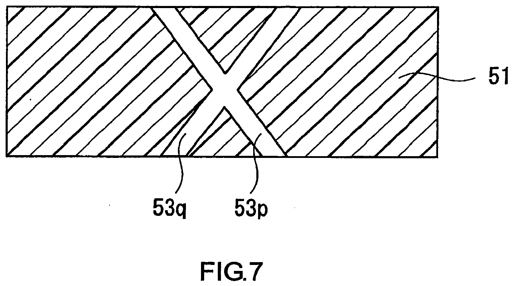

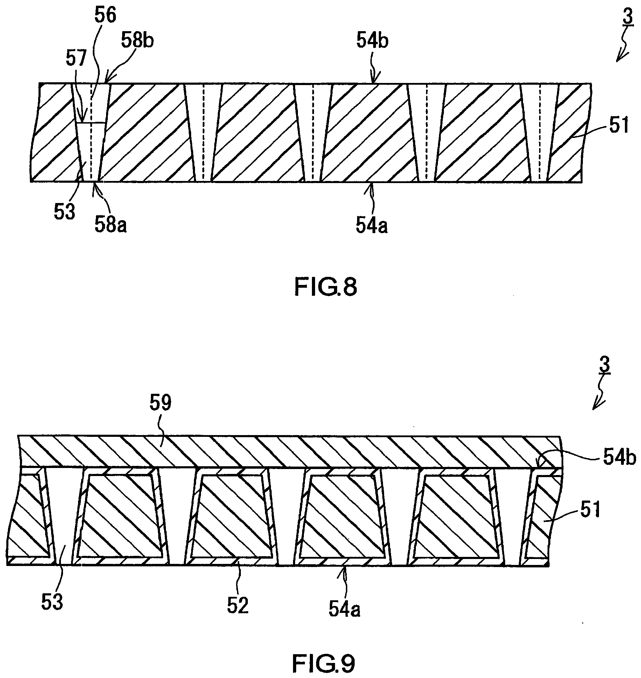

In the example shown in FIG. 3, the direction in which the through holes 53 extend is perpendicular to the principal surfaces 54a and 54b of the resin film 51. The direction in which the through holes 53 extend may be oblique to the direction perpendicular to the principal surfaces 54a and 54b of the resin film 51, as long as the through holes 53 extend through the thickness of the resin film 51. All of the through holes 53 present in the resin film 51 may extend in the same direction (that is, the directions of their central axes 56 may be identical). Alternatively, as shown in FIG. 4, the resin film 51 may have through holes 53 (53a to 53g) extending in oblique directions with respect to the direction perpendicular to the principal surfaces 54a and 54b of the film, and the oblique directions in which the through holes 53a to 53g of the resin film 51 extend may be different from each other. In the example shown in FIG. 4, there is a combination of through holes 53 extending (penetrating through the resin film 51) in oblique directions with respect to the direction perpendicular to the principal surfaces 54a and 54b of the resin film 51, the oblique directions being different from each other. In such a case, the resin film 51 may have a combination of through holes 53 extending in the same direction (the through holes 53a, 53d, and 53g extend in the same direction in the example shown in FIG. 4). The resin film 51 may have both a through hole 53 extending in the direction perpendicular to the principal surfaces 54a and 54b of the film and a through hole 53 extending obliquely to the perpendicular direction. The term "set" may hereinafter be used instead of "combination". The term "set" is used not only to refer to the relationship (a pair) between one through hole and another through hole but also to refer to the relationship between one or more through holes and one or more other through holes. Saying that there is a set of through holes having the same characteristics means that there are two or more through holes having the characteristics. In FIG. 4, the liquid-repellent layer is omitted (the same applies to FIGS. 7 and 8).

In the waterproof sound-permeable membrane 3 as shown in FIG. 4 which includes the resin film 51 having the through holes 53 extending in different oblique directions, the oblique angles and the proportion of the through holes 53 extending in each direction can be varied. This allows a high flexibility in control of the sound permeability and waterproofness of the waterproof sound-permeable membrane 3. The high flexibility contributes to achieving higher levels of both waterproofness and sound permeability of the waterproof sound transmission structure 1.

For the through holes 53 shown in FIG. 4, the angle θ1 formed by the oblique direction D1 (the direction of the central axis 56) with the direction D2 perpendicular to the principal surfaces of the resin film 51 is preferably 45° or less and more preferably 30° or less. When the angle θ1 falls within the preferable ranges, the flexibility in control of the sound permeability and waterproofness of the waterproof sound-permeable membrane 3 is increased. The lower limit of the angle θ1 is not particularly defined, and the angle θ1 is, for example, 10° or more and preferably 20° or more. If the angle θ1 is excessively large, the mechanical strength of the waterproof sound-permeable membrane 1 tends to decrease. The through holes 53 shown in FIG. 4 include a set of through holes for which the angles θ1 are different.

When the waterproof sound-permeable membrane 3 as shown in FIG. 4 which includes the resin film 51 having through holes 53 extending in different oblique directions is viewed in a direction perpendicular to a principal surface of the resin film 51, namely when the directions in which the through holes 53 extend are projected on the principal surface, the projected directions in which the through holes 53 extend may be parallel to each other. However, it is preferable that the resin film 51 have a set of through holes 53 for which the projected directions are different from each other (through holes 53 for which the projected directions are different from each other coexist in the resin film 51). In the latter case, the flexibility in control of the sound permeability and waterproofness of the waterproof sound-permeable membrane 3 is increased.

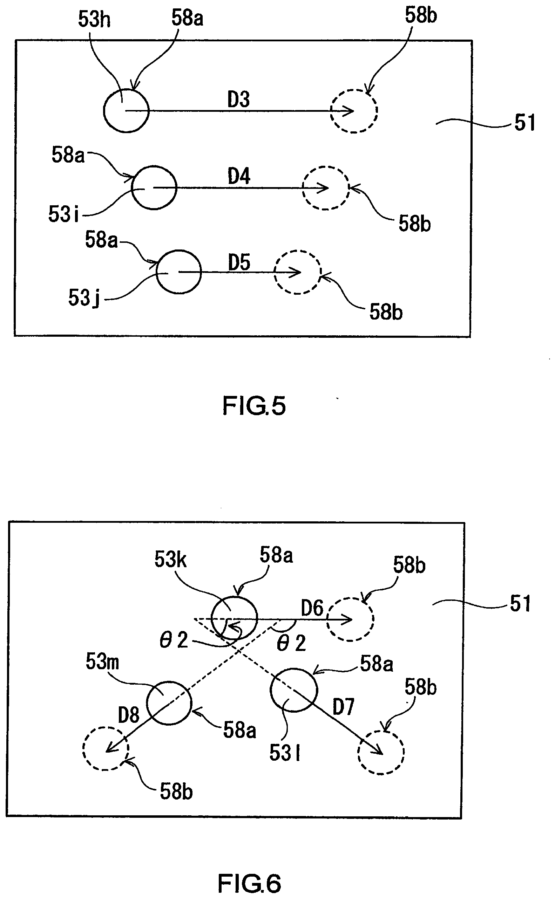

FIG. 5 shows an example where the directions in which the through holes 53 extend when viewed in a direction perpendicular to a principal surface of the resin film 51 are parallel to each other. In the example shown in FIG. 5, there can be seen three through holes 53 (53h, 53i, and 53j). In the view taken in a direction perpendicular to a principal surface of the resin film 51, the directions D3, D4, and D5 in which the three through holes 53 respectively extend (the directions from openings 58a of the through holes 53 at the principal surface depicted on the sheet plane toward openings 58b of the through holes 53 at the opposite principal surface) are parallel to each other (this means that θ2 described later is 0°). It should be noted that the angles θ1 formed by the through holes 53h, 53i, and 53j are different from each other. The angle θ1 formed by the through hole 53j is smallest, and the angle θ1 formed by the through hole 53h is largest. Thus, the directions in which the through holes 53h, 53i, and 53j extend are different from each other in three dimensions.

FIG. 6 shows an example where the directions in which the through holes 53 extend when viewed in a direction perpendicular to a principal surface of the resin film 51 are different from each other. In the example shown in FIG. 6, there can be seen three through holes 53 (53k, 531, and 53m). In the view taken in a direction perpendicular to a principal surface of the resin film 51, the directions D6, D7, and D8 in which the three through holes 53 respectively extend are different from each other. When viewed in a direction perpendicular to a principal surface of the resin film 51, the through holes 53k and 531 extend from the principal surface in different directions forming an angle θ2 of less than 90°. In contrast, the through holes 53k and 53m extend from the principal surface of the resin film 51 in different directions forming an angle θ2 of 90° or more when viewed in the direction perpendicular to the principal surface of the resin film 51. The latter set of through holes is preferred; that is, the resin film 51 preferably has a set of through holes 53 that, when viewed in a direction perpendicular to a principal surface of the film, extend from the principal surface in different directions forming an angle θ2 of 90° or more. In other words, the resin film 51, when viewed in a direction perpendicular to a principal surface of the film, preferably has a set of the through hole 53k extending from the principal surface in one direction D6 and the through hole 53m extending from the principal surface in another direction D8 forming an angle θ2 of 90° or more with the one direction D6. In this case, the flexibility in control of the sound permeability and waterproofness of the waterproof sound-permeable membrane 3 is further increased. The angle θ2 is preferably 90° or more and 180° or less, and may be 180°.

In the waterproof sound-permeable membrane 3 as shown in FIG. 5 which includes the resin film 51 having the through holes 53 extending in different oblique directions, two or more of the through holes 53 may cross each other at the inside of the resin film 51. That is, the resin film 51 may have a set of through holes 53 crossing each other at the inside of the film 51. In this case, the flexibility in control of the sound permeability and waterproofness of the waterproof sound-permeable membrane 3 is further increased. Such an example is shown in FIG. 7. In the example shown in FIG. 7, the through holes 53p and 53q cross each other at the inside of the resin film 51.

The directions in which the through holes 53 extend (the directions of the central axes 56 of the through holes 53) in the resin film 51 (in the waterproof sound-permeable membrane 3) can be known, for example, by observing the principal surfaces and a cross-section of the film 51 with a scanning electron microscope (SEM).

The shape of the openings of the through holes 53 at the principal surfaces 54a and 54b of the resin film 51 is not limited, and is typically circular (when the direction of the central axis 56 is perpendicular to the principal surfaces 54a and 54b of the resin film 51) or elliptic (when the direction of the central axis 56 is oblique to the direction perpendicular to the principal surfaces 54a and 54b of the resin film 51). In this case, the shape of the openings of the through holes 53 need not be exactly circular or elliptic. For example, some degree of shape distortion caused by unevenness of etching performed in the production method described later is acceptable. The same applies to the shape of the cross-section of the through holes 53.

In the examples shown in FIGS. 3 to 7, the diameter of the through holes 53 hardly varies from the first principal surface 54a of the resin film 51 to the second principal surface 54b. This means that the shape of the cross-section of the through holes 53 remains almost unchanged from the principal surface 54a to the principal surface 54b. As shown in FIG. 8, the through holes 53 of the waterproof sound-permeable membrane 3 may have a shape in which the area of a cross-section 57 perpendicular to the direction of the central axis 56 increases from the first principal surface 54a of the resin film 51 toward the second principal surface 54b. This makes it possible to achieve higher levels of both waterproofness and sound permeability of the waterproof sound-permeable membrane 3 (waterproof sound transmission structure 1). In this case, it is preferable to place the waterproof sound-permeable membrane 3 over the sound transmission port 11 of the wall 2 in such a manner that the principal surface 54a at which the diameter of the through holes 53 is relatively small faces the second space 12 where water can be present while the principal surface 54b at which the diameter of the through holes 53 is relatively large faces the first space 13. Each through hole 53 shown in FIG. 8 is a through hole having a shape that is asymmetrical in the thickness direction of the waterproof sound-permeable membrane 3 and whose cross-section 57 varies in shape in the direction of the central axis 56.

When the through holes 53 have a shape in which the area of the cross-section 57 perpendicular to the direction of the central axis 56 increases from the first principal surface 54a of the resin film 51 toward the second principal surface 54b, the through holes 53 may have the cross-section 57 that is circular or elliptic and whose area increases continuously from the principal surface 54a toward the principal surface 54b at a constant or substantially constant rate. In this case, the shape of the through holes 53 corresponds to the entirety or a part of a circular or elliptic cone whose central line coincides with the axial line 56. The below-described production method which employs ion beam irradiation and etching is capable of forming the waterproof sound-permeable membrane 3 including the resin film 51 having the through holes 53 whose cross-section 57 is circular or elliptic.

When the through holes 53 have a shape in which the area of the cross-section 57 perpendicular to the direction of the central axis 56 increases from the first principal surface 54a of the resin film 51 toward the second principal surface 54b, the ratio a/b of the smaller diameter (diameter a) of the through holes 53 at the principal surface 54a to the larger diameter (diameter b) of the through holes at the principal surface 54b is, for example, 80% or less. To further increase the flexibility in control of the waterproofness and sound permeability, the ratio a/b is preferably 75% or less and more preferably 70% or less. The lower limit of the ratio a/b is not particularly defined and is, for example, 10%.

The area of the cross-section 57 may increase continuously from the principal surface 54a toward the principal surface 54b or may increase stepwise from the principal surface 54a toward the principal surface 54b (this means that the through holes 53 may have a region over which the area of the cross-section 57 is constant). It is preferable that the area of the cross-section 57 increase continuously from the principal surface 54a toward the principal surface 54b as shown in FIG. 8, and it is more preferable that the increase rate be constant or substantially constant. The below-described production method which employs ion beam irradiation and etching is capable of forming: the waterproof sound-permeable membrane 3 including the resin film 51 having the through holes 53 having the cross-section 57 the area of which increases continuously from the principal surface 54a toward the principal surface 54b; and the waterproof sound-permeable membrane 3 in which the increase rate of the area is constant or substantially constant.

The above characteristics of the through holes 53 of the waterproof sound-permeable membrane 3 can be freely combined. For example, the through holes 53 may have a central axis 56 whose direction is oblique to a direction perpendicular to the principal surfaces 54a and 54b of the resin film 51 and have a shape in which the area of the cross-section 57 perpendicular to the direction of the central axis 56 increases from the first principal surface 54a of the resin film 51 toward the second principal surface 54b.

The through holes 53 have a diameter of 5.0 µm or more and 13.0 µm or less. When, as shown in FIG. 8, the through holes 53 have a shape in which the area of the cross-section 57 perpendicular to the direction of the central axis 56 increases from the first principal surface 54a of the resin film 51 toward the second principal surface 54b, the smaller diameter (the diameter of the through holes 53 at the principal surface 54a in the example shown in FIG. 8) is 5.0 µm or more and 13.0 µm or less.

The diameter (opening diameter) of a through hole 53 is determined as the diameter of a circle on the assumption that the opening of the through hole has the shape of the circle. In other words, the diameter of a through hole 53 is defined to correspond to the diameter of a circle having an area equal to the cross-sectional area (opening area) of the opening of the through hole. The diameters of the through holes 53 can be determined by observing the surfaces of the waterproof sound-permeable membrane 3 or resin film 51 with a microscope and analyzing the microscopic image. The diameters of the openings of the through holes 53 at each principal surface of the resin film 51 need not be exactly equal for all of the openings lying at the principal surface. However, it is preferable for the diameters in the effective portion of the resin film 51 (the portion that can be used in the waterproof sound-permeable membrane 3) to be so uniform that the diameters can be considered substantially equal (e.g., the standard deviation is 10% or less of the average). The below-described production method which employs ion beam irradiation and etching is capable of forming the waterproof sound-permeable membrane 3 in which the through holes have such uniform diameters.

A through hole 53 extending obliquely to the direction perpendicular to the principal surfaces 54a and 54b of the resin film 51 can have an opening of elliptic shape. Also in such a case, the cross-section 57 of the through hole 53 inside the film 51 can be considered to be in the shape of a circle, and the diameter of this circle is equal to the minor axis of the ellipse corresponding to the shape of the opening. Thus, for the through hole 53 extending obliquely and having an opening of elliptic shape, the minor axis of the ellipse can be regarded as the opening diameter of the through hole.

It is preferable for the waterproof sound-permeable membrane 3 to have an air permeability of 2.0 cm³/(cm²•sec) or more and 120 cm³/(cm²•sec) or less as expressed in terms of Frazier number measured according to JIS L 1096 in the thickness direction of the waterproof sound-permeable membrane 3. The air permeability being in this range, coupled with the diameter of the through holes 53 which falls within the range described above, ensures improved sound permeability of the waterproof sound-permeable membrane 3 and the waterproof sound transmission structure 1 including the membrane, and allows the membrane and structure to have higher levels of both waterproofness and sound permeability. The air permeability of the waterproof sound-permeable membrane 3, as expressed in terms of Frazier number, is preferably 10.0 cm³/(cm²•sec) or more and 120 cm³/(cm²•sec) or less. The lower limit of the air permeability can be 50.0 cm³/(cm²•sec) or more or 90 cm³/(cm²•sec) or more. When the air permeability is in such a range, the diameter of the through holes 53 is preferably within the desired range described above.

When, as shown in FIG. 8, the waterproof sound-permeable membrane 3 has the through holes 53 having the cross-section 57 the area of which increases from the first principal surface 54a toward the second principal surface 54b, the air permeability of the membrane 3 in the direction from the second principal surface 54b, at which the diameter of the through holes 53 is larger, to the first principal surface 54a, at which the diameter of the through holes 53 is smaller, is preferably within the above range as expressed in terms of Frazier number.

Given that the liquid-repellent layer 52 has almost no influence on the air permeability of the waterproof sound-permeable membrane 3, the air permeability of the resin film 51 is preferably within the range described above for the air permeability of the waterproof sound-permeable membrane 3.

The density of the through holes 53 (hole density) in the waterproof sound-permeable membrane 3 (or in the resin film 51) is not particularly limited and is, for example, 1 × 10³ holes/cm² or more and 1 × 10⁹ holes/cm² or less. When the hole density is in this range, the waterproofness and sound permeability of the waterproof sound-permeable membrane 3 can be controlled within the preferred ranges, and higher levels of both of the properties can be achieved. The hole density is more preferably 1 × 10⁵ holes/cm² or more and 1 × 10⁸ holes/cm² or less. The hole density need not be exactly constant over the entirety of the waterproof sound-permeable membrane 3. However, the hole density in the effective portion of the membrane is preferably so uniform that the maximum value of the hole density is equal to or less than 1.5 times the minimum value of the hole density. The hole density can be determined, for example, by observing the surfaces of the waterproof sound-permeable membrane 3 or resin film 51 with a microscope and analyzing the microscopic image.

The opening area ratio in the waterproof sound-permeable membrane 3 (or in the resin film 51) is preferably 50% or less, more preferably 10% or more and 45% or less, and even more preferably 20% or more and 40% or less. The opening area ratio refers to the ratio of the sum of the areas of the openings of the through holes 53 at a principal surface of the membrane or resin film to the area of the principal surface. When the opening area ratio is in such a range, the waterproofness and sound permeability of the waterproof sound-permeable membrane 3 can be controlled within the preferred ranges, and higher levels of both of the properties can be achieved. In addition, the opening area ratio being in the above range, coupled with the diameter of the through holes 53 which falls within the range described above, allows the waterproof sound-permeable membrane 3 to have good sound permeability even if, for example, the membrane has a reduced effective area. The opening area ratio can be determined, for example, by observing the surfaces of the waterproof sound-permeable membrane 3 or resin film 51 with a microscope and analyzing the microscopic image.

When, as shown in FIG. 8, the waterproof sound-permeable membrane 3 has the through holes 53 having the cross-section 57 the area of which increases from the first principal surface 54a toward the second principal surface 54b, the opening area ratio is preferably in the above range for the principal surface 54a at which the diameter of the through holes is smaller.

The porosity of the waterproof sound-permeable membrane 3 (or of the resin film 51) is preferably 25% or more and 45% or less and more preferably 30% or more and 40% or less. When the porosity is in such a range, the waterproofness and sound permeability of the waterproof sound-permeable membrane 3 can be controlled within the preferred ranges, and higher levels of both of the properties can be achieved. When the diameter of the through holes 53 is in the range described above, the waterproof sound-permeable membrane 3 can have good sound permeability even if, for example, the membrane has a reduced effective area, and when the state where the air permeability of the waterproof sound-permeable membrane 3 is in the range described above is further established, the sound permeability can be further improved even if, for example, the membrane has a reduced effective area. When the waterproof sound-permeable membrane 3 has the through holes 53 having the cross-section 57 the area of which is constant in the resin film 51 as shown in FIG. 3, the opening area ratio corresponds to the porosity. When, as shown in FIG. 8, the waterproof sound-permeable membrane 3 has the through holes 53 having the cross-section 57 the area of which increases from the first principal surface 54a toward the second principal surface 54b, the porosity can be determined, for example, by calculation based on the opening area ratios in both of the principal surfaces 54a and 54b and on the shape of the through holes 53 which is confirmed by observing a cross-section of the waterproof sound-permeable membrane 3 (or of the resin film 51).

As previously described, the waterproofness of the waterproof sound-permeable membrane 3 can be evaluated, for example, by a water entry pressure measured for the membrane 3 according to the Method B of water penetration test. When, as shown in FIG. 8, the waterproof sound-permeable membrane 3 has the through holes 53 having the cross-section 57 the area of which increases from the first principal surface 54a toward the second principal surface 54b, the water entry pressure may be evaluated by applying a water pressure to the principal surface of the membrane 3 that is to face the second space 12 when the membrane 3 is placed in the waterproof sound transmission structure 1. Given that the water entry pressure of the membrane 3 is greater when the principal surface 54a, at which the diameter of the through holes 53 is smaller, is exposed to water than when the principal surface 54b, at which the diameter of the through holes 53 is larger, is exposed to water, the membrane 3 may be placed in the waterproof sound transmission structure 1 in such a manner that the principal surface 54a faces the second space 12 where water can be present.

The sound permeability of the waterproof sound-permeable membrane 3 can be such that, for example, the insertion loss in the frequency range of 100 Hz to 5 kHz is 5 dB or less, 3 dB or less, 2 dB or less, or even 1 dB or less. The insertion loss in the frequency range of 100 Hz to 3 kHz can be 5 dB or less, 3 dB or less, 2 dB or less, or even 1 dB or less. The frequencies ranging from 100 Hz to 5 kHz are those that humans use in their usual vocalization and conversation and correspond to those that humans can perceive most sensitively when listening to played-back music etc. The small insertion loss in this frequency range enhances the market appeal of an electronic device including the waterproof sound-permeable membrane 3. For example, the insertion loss caused by the waterproof sound-permeable membrane 3 at a frequency of 1 kHz, which is considered a median in the frequency range of human voice, can be 5 dB or less, 3 dB or less, or even 1 dB or less.

The waterproof sound-permeable membrane 3 has the liquid-repellent layer 52. The liquid-repellent layer 52 can be formed, for example, by liquid-repellent treatment of the resin film 51. In the example shown in FIG. 3, the liquid-repellent layer 52 is formed on both of the principal surfaces 54a and 54b of the resin film 51 and on the surfaces of the through holes 53. The liquid-repellent layer 52 may be formed only on one principal surface of the resin film 51 or may be formed only on one principal surface and the surfaces of the through holes 53. The liquid-repellent layer 52 is preferably formed at least on one principal surface that faces the first principal surface 12 where water can be present when the membrane 3 is attached to the waterproof sound transmission structure 1. When, as shown in FIG. 8, the waterproof sound-permeable membrane 3 has the through holes 53 having the cross-section 57 the area of which increases from the first principal surface 54a toward the second principal surface 54b, it is preferable to form the liquid-repellent layer 52 on the principal surface 54a at which the diameter of the through holes 53 is smaller, given the above-mentioned difference in water entry pressure depending on which of the principal surfaces is exposed to water.

The liquid-repellent layer 52 is a water-repellent layer and preferably further has oil repellency. The liquid-repellent layer 52 has openings positioned in correspondence with the through holes 53 of the resin film 51.

The liquid-repellent layer 52 can be formed, for example, as follows: A treatment liquid prepared by diluting a water-repellent agent or hydrophobic oil-repellent agent with a diluent is thinly applied and dried on the resin film 51. Examples of the water-repellent agent and hydrophobic oil-repellent agent include fluorine compounds such as perfluoroalkyl acrylate and perfluoroalkyl methacrylate. The thickness of the liquid-repellent layer 52 is preferably less than 1/2 of the diameter of the through holes 53.

When the liquid-repellent layer 52 is formed by thinly applying a treatment liquid onto the resin film 51, the surfaces (inner peripheral surfaces) of the through holes 53 can, depending on their diameter, be coated with the liquid-repellent layer 52 extending continuously from the principal surfaces of the resin film 51 (this is the case for the example shown in FIG. 3).

The thickness of the resin film 51 and the thickness of the waterproof sound-permeable membrane 3 are, for example, 5 µm or more and 100 µm or less and preferably 15 µm or more and 50 µm or less.

The material composing the resin film 51 is, for example, a material that allows the below-described production method to form the through holes 53 in an original film which is a non-porous resin film. The resin film 51 is composed of, for example, a resin degradable by an alkaline solution, an acidic solution, or an alkaline or acidic solution to which has been added at least one selected from an oxidant, an organic solvent, and a surfactant. In this case, the formation of the through holes 53 in the original film by ion beam irradiation and chemical etching becomes easier in the below-described production method. The solutions as mentioned above are typical etchants. From another standpoint, the resin film 51 is composed of, for example, a resin that can be etched by hydrolysis or oxidative degradation. The original film used can be a commercially-available film.

The resin film 51 is composed of, for example, at least one resin selected from polyethylene terephthalate (PET), polycarbonate, polyimide, polyethylene naphthalate, and polyvinylidene fluoride.

The waterproof sound-permeable membrane 3 may include two or more resin films 51. Such a waterproof sound-permeable membrane 3 can be formed, for example, by ion beam irradiation and chemical etching of a stack of two or more original films.

The waterproof sound-permeable membrane 3 may, if desired, include any member and/or layer other than the resin film 51 and liquid-repellent layer 52. An example of the member is an air-permeable supporting layer 59 shown in FIG. 9. In the waterproof sound-permeable membrane 3 shown in FIG. 9, the air-permeable supporting layer 59 is placed on the principal surface 54b of the resin film 51 of the waterproof sound-permeable membrane 3 shown in FIG. 8. The placement of the air-permeable supporting layer 59 improves the strength and handling properties of the waterproof sound-permeable membrane 3. The air-permeable supporting layer 59 may be placed on the principal surface 54a of the resin film 51 or on both of the principal surfaces 54a and 54b.

The air-permeable supporting layer 59 has a higher air permeability in the thickness direction than the resin film 51. The air-permeable supporting layer 59 used can be, for example, a woven fabric, non-woven fabric, net, or mesh. Examples of the material composing the air-permeable supporting layer 59 include polyester, polyethylene, and aramid resin. The liquid-repellent layer 52 may or may not be formed on the principal surface of the resin film 51 on which the air-permeable supporting layer 59 is to be placed. The shape of the air-permeable supporting layer 59 may be the same as or different from the shape of the resin film 51. For example, the air-permeable supporting layer 59 can have a shape adapted for placement only on the peripheral portion of the resin film 51 (in particular, a ring shape adapted for placement only on the peripheral portion of the resin film that is circular). The air-permeable supporting layer 59 is placed, for example, by a technique such as thermal welding, or bonding by an adhesive, to the resin film 51.

The surface density of the waterproof sound-permeable membrane 3 is preferably 5 to 100 g/m² and more preferably 10 to 50 g/m², in terms of the strength, production yield, handling properties including attachment accuracy, and sound permeability of the membrane.

The waterproof sound-permeable membrane 3 may be subjected to a coloring treatment. Depending on the type of the material composing the resin film 51, the waterproof sound-permeable membrane 3 not subjected to any coloring treatment is, for example, transparent or white. Such a waterproof sound-permeable membrane 3 may be conspicuous when the membrane 3 is placed to cover a sound transmission port of a housing. Such a conspicuous membrane may so stimulate the curiosity of a user as to induce the user to stab the waterproof sound-permeable membrane with a needle or the like, thereby impairing the function of the membrane as a waterproof sound-permeable membrane. When the waterproof sound-permeable membrane 3 has been subjected to a coloring treatment so that, for example, the membrane 3 has a color identical or similar to the color of the housing, the potential to attract the user's attention can be relatively reduced. In some cases, a colored waterproof sound-permeable membrane is required in view of the visual appearance of the housing of an electronic device or the like. Such a requirement as to visual appearance can be met by means of the coloring treatment.

The coloring treatment can be accomplished, for example, by dyeing the resin film 51 or by incorporating a colorant into the resin film 51. The coloring treatment may be carried out, for example, so as to enable absorption of light in the wavelength range of 380 nm to 500 nm. That is, the waterproof sound-permeable membrane 3 may be subjected to a coloring treatment that enables the membrane 3 to absorb light in the wavelength range of 380 nm to 500 nm. To this end, for example, the resin film 51 contains a colorant having the ability to absorb light in the wavelength range of 380 nm to 500 nm or is dyed with a dye having the ability to absorb light in the wavelength range of 380 nm to 500 nm. In this case, the waterproof sound-permeable membrane 3 can be colored, for example, blue, gray, brown, pink, green, or yellow. The waterproof sound-permeable membrane 3 may be colored black, gray, brown, or pink.

The degree of coloring is preferably such that the whiteness W described below is in the range of 10.0 to 70.0. The whiteness W can be determined as follows: The lightness L, hue a, and chroma b of a principal surface of the waterproof sound-permeable membrane 3 are measured using a color-difference meter according to JIS L 1015 (Hunter method), and the whiteness W is calculated by the equation: W = 100 - sqr[(100 - L)² + (a² + b²)]. The lower the value of the whiteness W is, the blacker the waterproof sound-permeable membrane 3 is.

The method for producing the waterproof sound-permeable membrane 3 is not particularly limited. For example, the waterproof sound-permeable membrane 3 can be produced by the production method described below.

### (Method for producing waterproof sound-permeable membrane)

In the production method which will be described hereinafter, the resin film 51 is formed by ion beam irradiation and the subsequent etching (chemical etching) of an original film. The resin film 51 formed by ion beam irradiation and etching can be processed into the waterproof sound-permeable membrane 3 through a step of forming the liquid-repellent layer 52 and optionally an additional step such as a step of performing a coloring treatment or stacking the air-permeable supporting layer 59.

With the method which employs ion beam irradiation and the subsequent etching, it is easy, for example, to control various properties such as the diameters of the through holes 53 of the resin film 51, the uniformity of the diameters, the direction of the central axis 56, the hole density, the opening area ratio, and the porosity. This means that the waterproofness and sound permeability of the waterproof sound-permeable membrane 3 can easily be controlled.

The original film is a non-porous resin film having no passage that allows through-thickness air permeation in its portion that is processed into the waterproof sound-permeable membrane 3 through ion beam irradiation and etching. The original film may be an imperforate film. The fact that the original film is a non-porous resin film means that when the original film is irradiated with an ion beam and then chemically etched to form the through holes 53 and thus obtain the resin film 51, the uniformity and surface smoothness of the film 51 can be made higher than, for example, those of a woven structure such as a mesh or of a non-woven fabric structure. This contributes to improvement in the waterproofness and sound permeability of the waterproof sound-permeable membrane 3 and therefore of the waterproof sound transmission structure 1.

When the original film is irradiated with an ion beam, the polymer chains constituting the resin film are bombarded with and damaged by ions in those portions of the film through which the ions pass. The damaged polymer chains are more susceptible to chemical etching than the other polymer chains not bombarded with the ions. Chemical etching of the ion beam-irradiated original film thus results in a resin film having minute holes (through holes) extending along the tracks of the bombarding ions. That is, the directions of the central axes 56 of the through holes 53 coincide with the directions in which the ions have passed through the original film during the ion beam irradiation. In general, those portions of the original film through which no ions have passed have no minute holes formed therein.

This process for forming the resin film 51 from the original film may include the steps of (I) irradiating the original film with an ion beam; and (II) chemically etching at least part of the ion-bombarded portions of the ion beam-irradiated original film to form through holes 53 extending along the tracks (ion tracks) of the bombarding ions in the film. This process is capable of forming the resin film 51 as shown in FIG. 3 which has the through holes 53 having the cross-section 57 (cross-section perpendicular to the direction of the central axis 56) the area of which is constant or substantially constant from the first principal surface 54a toward the second principal surface 54b, and is also capable of forming the resin film 51 having the through holes 53 in which the cross-sectional area increases from the first principal surface 54a toward the second principal surface 54b. The resin film 51 of the former kind can be formed, for example, by chemically etching the ion-irradiated original film directly. The etching removes the portions corresponding to the ion tracks formed in the original film. Thus, the through holes 53 whose cross-section 57 has a constant or substantially constant area are formed by allowing the chemical etching to proceed over a sufficiently long time.

The resin film 51 of the latter kind can be formed, for example, by carrying out the chemical etching in the step (II) in such a manner that the extent of the etching of the ion-bombarded portions from one principal surface is greater than the extent of the etching of the ion-bombarded portions from the other principal surface. Specifically, for example, the resin film can be formed by performing the chemical etching with a masking layer placed on one principal surface of the ion-irradiated original film. In this chemical etching, the extent of the etching from the other principal surface is greater than the extent of the etching from the one principal surface with the masking layer placed thereon. Such non-uniform etching, in particular etching in which the rate of etching from one principal surface of the ion-irradiated original film and the rate of etching from the other principal surface are different, is capable of forming the through holes 53 having a shape in which the area of the cross-section 57 perpendicular to the direction of the central axis 56 increases from one principal surface of the resin film 51 toward the other principal surface of the resin film 51. In the etching process for forming the resin film 51 of the former kind without the use of a masking layer, the etching of the ion beam-irradiated original film progresses uniformly from both principal surfaces of the original film.

Hereinafter, the steps (I) and (II) will be described in more detail.

### [Step (I)]

In the step (I), an original film is irradiated with an ion beam. The ion beam is composed of accelerated ions. The irradiation with an ion beam causes the original film to be bombarded with the ions in the beam.

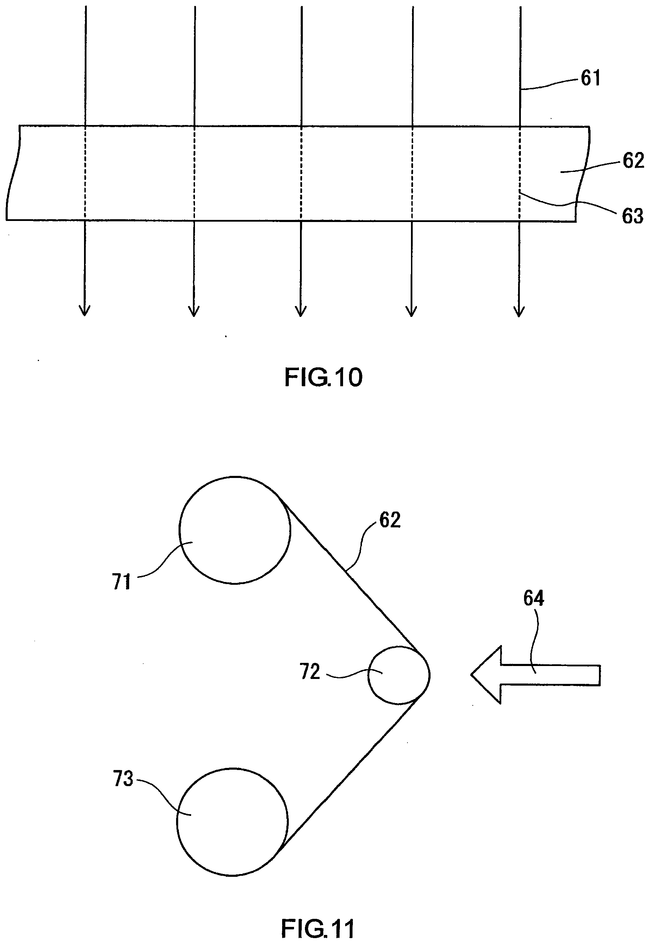

FIG. 10 illustrates irradiation of an original film with an ion beam. Ions 61 in the beam collide with an original film 62, and the ions 61 having collided with the film 62 leave tracks (ion tracks) 63 within the film 62. When viewed on the size scale of the original film 62 to be irradiated, the ions 61 bombard the original film 62 typically along a substantially straight line, thus forming the tracks 63 extending substantially straight in the film 62. In general, the ions 61 penetrate through the original film 62.

The method for irradiating the original film 62 with the ion beam is not limited. For example, the original film 62 is placed in a chamber, the internal pressure of the chamber is reduced (for example, a high vacuum atmosphere is created in the chamber to prevent energy attenuation of the bombarding ions 61), and then the ions 61 are emitted from a beamline to irradiate the original film 62. A particular gas may be introduced into the chamber. Alternatively, ion beam irradiation of the original film 62 placed in the chamber may be carried out, for example, at atmospheric pressure without reduction in the internal pressure of the chamber.

It is also conceivable to prepare a roll on which the original film 62 in the form of a long sheet is wound and continuously irradiate the original film 62 with the ion beam while feeding the original film 62 from the roll. This allows efficient formation of the resin film 51. It is also conceivable to dispose the roll (feed roll) and a take-up roll for winding up the ion beam-irradiated original film 62 in the chamber described above, create an appropriate atmosphere such as a reduced-pressure or high vacuum atmosphere in the chamber, then continuously irradiate the original film 62 in the form of a long sheet with the ion beam while feeding the film from the feed roll, and then wind the beam-irradiated original film 62 on the take-up roll.

The resin composing the original film 62 is identical to the resin composing the resin film 51 and is, for example, at least one selected from PET, polycarbonate, polyimide, polyethylene naphthalate, and polyvinylidene fluoride. The original film 62 composed of at least one of these resins is characterized in that chemical etching progresses smoothly in those portions of the film which have been bombarded with the ions 61, while chemical etching progresses slowly in the rest of the film. This allows easier control of chemical etching of those portions of the original film 62 which correspond to the tracks 63. Thus, for example, the use of such an original film 62 makes easier the control of the shape of the through holes 53 of the resin film 51.

The original film 62 may be composed of two or more resins and may contain a material different from resins, as long as the resin film 51 can be formed through the steps (I) and (II). Examples of the material include: additives such as a light stabilizer and an antioxidant; oligomer components derived from resin materials; and metal oxides (such as white pigments, including alumina and titanium oxide).

The thickness of the original film 62 is, for example, 5 to 100 µm. In general, the thickness of the original film 62 remains unchanged before and after the ion beam irradiation in the step (I).

The original film 62 to be irradiated with the ion beam is, for example, an imperforate film. In this case, the resin film 51 having no holes other than the through holes 53 formed by the steps (I) and (II) can be obtained unless an additional step of forming holes in the film is performed in addition to the steps (I) and (II). When the additional step is performed, the resulting resin film 51 has the through holes 53 formed by the steps (I) and (II) and holes formed by the additional step.

The type of the ions 61 with which the original film 62 is irradiated and bombarded is not limited. It is preferable for the ions to include ions having a larger mass number than neon, specifically at least one species selected from argon ions, krypton ions, and xenon ions, since these ions do not readily chemically react with the resin composing the original film 62.

The energy (acceleration energy) of the ions 61 is typically 100 to 1000 MeV. When the original film 62 used is a polyester film having a thickness of about 5 to 100 µm and the ions 61 are argon ions, the energy of the ions 61 is preferably 100 to 600 MeV. The energy of the ions 61 to be applied to the original film 62 can be adjusted depending on the type of the ions and on the type of the resin composing the original film 62.

The ion source of the ions 61 to be applied to the original film 62 is not limited. For example, the ions 61 emitted from the ion source are accelerated by an ion accelerator, then passed through a beamline, and applied to the original film 62. The ion accelerator is, for example, a cyclotron, a specific example of which is an AVF cyclotron.

The pressure in the beamline serving as a path of the ions 61 is preferably a high vacuum pressure of about 10⁻⁵ to 10⁻³ Pa, in terms of preventing the energy attenuation of the ions 61 in the beamline. When the pressure in the chamber enclosing the original film 62 to be irradiated with the ions 61 does not reach a high vacuum pressure, a partition permeable to the ions 61 may be used to maintain the pressure difference between the beamline and the chamber. The partition is made up of, for example, a titanium membrane or aluminum membrane.

The ions 61 are applied to the original film 62, for example, in a direction perpendicular to the principal surfaces of the film. The irradiation in the example shown in FIG. 10 is performed in this manner. In this case, the tracks 63 extend perpendicular to the principal surfaces of the original film 62; thus, the subsequent chemical etching results in the resin film 51 having through holes 53 formed to have a central axis 56 extending in the direction perpendicular to the principal surfaces of the resin film 51. The ions 61 may be applied to the original film 62 in a direction oblique to the principal surfaces of the film. In this case, the subsequent chemical etching results in the resin film 51 having through holes 53 formed to have a central axis 56 extending in a direction oblique to the direction perpendicular to the principal surfaces of the resin film 51. The direction of the ions 61 applied to the original film 62 can be controlled by known means. The angle θ1 shown in FIG. 4 can be controlled, for example, by adjusting the incident angle of the ion beam to the original film 62.

The ions 61 are applied to the original film 62, for example, in such a manner that the trajectories of the ions 61 are parallel to each other. The irradiation in the example shown in FIG. 10 is performed in this manner. In this case, the subsequent chemical etching results in the resin film 51 having through holes 53 formed to extend parallel to each other.

The ions 61 may be applied to the original film 62 in such a manner that the trajectories of the ions 61 are non-parallel to each other (random with respect to each other, for example). This results in, for example, the resin film 51 as shown in any of FIGS. 4 to 7. Specifically, for example, a possible method for forming the resin film 51 as shown in any of FIGS. 4 to 7 is to apply the ion beam to the original film 62 in a direction oblique to the direction perpendicular to the principal surfaces of the original film 62 while changing the oblique direction continuously or stepwise. Since the ion beam is composed of ions traveling parallel to each other, the resin film 51 typically has a set of through holes 53 extending in the same direction (there are typically two or more through holes 53 extending in the same direction in the resin film 51).

FIG. 11 shows an example of the method in which the oblique direction is changed continuously or stepwise. In the example shown in FIG. 11, the original film 62 in the form of a long sheet is fed from a feed roll 71, passed through an irradiation roll 72 with a predetermined curvature, and irradiated with an ion beam 64 while moving on the roll 72, after which the irradiated original film 62 is wound on a take-up roll 73. During this process, the ions 61 in the ion beam 64 travel parallel to each other and reach the original film 62 successively. Thus, the angle (incident angle θ1) at which the ion beam collides with the principal surface of the original film 62 varies with the movement of the original film 62 on the irradiation roll 72. Continuous emission of the ion beam 64 allows continuous change of the oblique direction, while intermittent emission of the ion beam 64 allows stepwise change of the oblique direction. Such control can be considered to be based on ion beam emission timing. The properties (for example, angle θ1) of the tracks 63 to be formed in the original film 62 can be controlled also by adjusting the cross-sectional shape of the ion beam 64 and the cross-sectional area of the beamline of the ion beam 64 formed on the area of the irradiation target surface of the original film 62.

The hole density of the resin film 51 can be controlled by the conditions of the irradiation of the original film 62 with the ion beam (such as the type of the ions, the energy of the ions, and the density of the bombarding ions (irradiation density)).

The ions 61 may be emitted from two or more beamlines to irradiate the original film 62.

The step (I) may be performed in the presence of a masking layer on a principal surface, such as the one principal surface as described above, of the original film 62. In this case, for example, the masking layer can be used also in the step (II).

### [Step (II)]

The original film 62 irradiated with the ion beam in the step (I) has portions bombarded with the ions 61 and, in the step (II), at least part of the ion-bombarded portions are chemically etched to form through holes 53 extending along the tracks 63 of the bombarding ions 61 in the film. The resin film 51 thus obtained is basically identical to the original film 62 yet to be subjected to the ion beam irradiation except for the presence of the through holes 53, unless another step of modifying the nature of the film is performed.

The specific technique employed for the etching may be the same as any of known techniques. For example, the ion beam-irradiated original film 62 may be immersed in an etchant at a predetermined temperature for a predetermined time. Adjusting the etching conditions such as the etching temperature, the etching time, and the composition of the etchant allows, for example, control of the diameter of the through holes 53.

The etching temperature is, for example, 40 to 150°C, and the etching time is, for example, 10 seconds to 60 minutes.

The etchant used in the chemical etching is not particularly limited. The etchant is, for example, an alkaline solution, an acidic solution, or an alkaline or acidic solution to which has been added at least one selected from an oxidant, an organic solvent, and a surfactant. The alkaline solution is, for example, a solution (typically an aqueous solution) containing a base such as sodium hydroxide or potassium hydroxide. The acidic solution is, for example, a solution (typically an aqueous solution) containing an acid such as nitric acid or sulfuric acid. The oxidant is, for example, potassium dichromate, potassium permanganate, or sodium hypochlorite. The organic solvent is, for example, methanol, ethanol, 2-propanol, ethylene glycol, amino alcohol, N-methylpyrrolidone, or N,N-dimethylformamide. The surfactant is, for example, an alkyl benzenesulfonic acid salt or an alkyl sulfuric acid salt.

In the step (II), the chemical etching is performed in the presence of a masking layer on one principal surface of the ion beam-irradiated original film 62. In this chemical etching of those portions of the original film 62 which have been bombarded with the ions 61, the extent of etching from the other principal surface is greater than the extent of etching from the one principal surface with the masking layer thereon. That is, the chemical etching of those portions of the original film 62 which have been bombarded with the ions 61 is performed in such a manner that the etching from one principal surface of the film and the etching from the other principal surface of the film progress in a non-uniform fashion (such etching may be referred to as "non-uniform etching"). Saying that "the extent of etching is great" specifically means, for example, that the amount of etching of the ion-bombarded portions per unit time is large, namely, that the rate of etching of the portions is high.

In the step (II), a masking layer more resistant to chemical etching than those portions of the original film 62 which have been bombarded with the ions 61 may be placed on one principal surface of the original film 62 to perform chemical etching in which the etching of the portions from the other principal surface of the original film 62 is allowed to progress while the etching of the portions from the one principal surface is inhibited. Such etching can be accomplished, for example, by appropriately selecting the type and thickness of the masking layer, the manner of the placement of the masking layer, and the etching conditions.

The type of the masking layer is preferably, but not limited to, a layer composed of a material more resistant to chemical etching than those portions of the original film 62 which have been bombarded with the ions 61. Saying that a material is "resistant to etching" specifically means, for example, that the amount of the material etched per unit time is small, namely, that the rate at which the material is etched is low. Whether a material is resistant to chemical etching can be determined on the basis of the conditions (such as the type of the etchant, the etching temperature, and the etching time) of the non-uniform etching to be actually performed in the step (II). When, in the step (II), non-uniform etching is performed a plurality of times by changing the type of the masking layer and/or alternating the surface on which the layer is placed, whether a material is resistant to chemical etching can be determined for each etching on the basis of the etching conditions.

The masking layer may be more susceptible or more resistant to chemical etching than those portions of the original film 62 which have not been bombarded with the ions 61. The masking layer is preferably more resistant to chemical etching than such portions. In this case, for example, the thickness required of the masking layer used in the non-uniform etching can be decreased.

When the original film 62 with a masking layer thereon is irradiated with the ion beam in the step (I), ion tracks are formed also in the masking layer. Given this, the material composing the masking layer is preferably a material having polymer chains resistant to damage by ion beam irradiation.

The masking layer is composed of, for example, at least one selected from polyolefin, polystyrene, polyvinyl chloride, polyvinyl alcohol, and a metal foil. These materials are resistant to chemical etching as well as being resistant to damage by ion beam irradiation.

When a masking layer is used to perform non-uniform etching, the masking layer should be placed on at least a portion of one principal surface of the original film 62, the portion corresponding to the area to be subjected to the non-uniform etching. It should be understood that the masking layer can be placed over the entirety of one principal surface of the original film 62 if desired.

The method for placing the masking layer on a principal surface of the original film 62 is not limited as long as the masking layer is not separated from the principal surface during the non-uniform etching. The masking layer is placed on the principal surface of the original film 62, for example, by means of an adhesive. That is, in the step (II), the chemical etching (non-uniform etching) may be performed in the presence of a masking layer bonded to the one principal surface of the original film 62 by means of an adhesive. It is relatively easy to dispose the masking layer by means of an adhesive. Appropriately selecting the type of the adhesive makes it easy to separate the masking layer from the original film 62 after the non-uniform etching.

When the non-uniform etching is performed in the step (II), this etching may be performed a plurality of times. Uniform etching in which etching of the tracks 63 is allowed to progress uniformly from both principal surfaces of the original film 62 may be performed in combination with the non-uniform etching. For example, the masking layer may be separated from the original film 62 in the course of the etching to switch the mode of etching from the non-uniform etching to the uniform etching. Alternatively, the masking layer may be placed on the original film 62 after the end of the uniform etching to subsequently perform the non-uniform etching.

When the non-uniform etching employing a masking layer is performed in the step (II), a part or the whole of the masking layer may, if desired, be allowed to remain on the resin film 51 after the etching. The masking layer remaining on the resin film 51 can be used, for example, as an indicator for differentiating between the one principal surface (the principal surface with the masking layer thereon) of the resin film 51 and the other principal surface of the resin film 51.

When etching is performed a plurality of times in the step (II), the etching conditions may be changed for each time of etching.

The method for producing the resin film 51 may include any step other than the steps (I) and (II).

How to place the waterproof sound-permeable membrane 3 on the wall 2 in the waterproof sound transmission structure 1 is not particularly limited, as long as the waterproof sound-permeable membrane 3 is placed to cover the sound transmission port 11 of the wall 2. For the placement of the waterproof sound-permeable membrane 3 on the wall 2, techniques such as adhesion using a double-sided tape, thermal welding, high-frequency welding, and ultrasonic welding can be employed. Adhesion using a double-sided tape is preferred, because the double-sided tape can be used as a supporting member for the waterproof sound-permeable membrane 3 and because the waterproof sound-permeable membrane 3 can be attached accurately and securely.

The supporting member for the waterproof sound-permeable membrane 3 is a member that reinforces the membrane 3 and improves the handling properties of the membrane 3. The supporting member is placed, for example, on a peripheral portion of the waterproof sound-permeable membrane 3. When the waterproof sound-permeable membrane 3 is circular as viewed in the direction perpendicular to its principal surfaces, the supporting member is, for example, a ring-shaped sheet joined to the peripheral portion of the membrane 3. The supporting member can function as a portion to be attached to the wall 2 when the waterproof sound-permeable membrane 3 is placed on the wall 2, and this enables more accurate and secure placement of the membrane 3 on the wall 2.

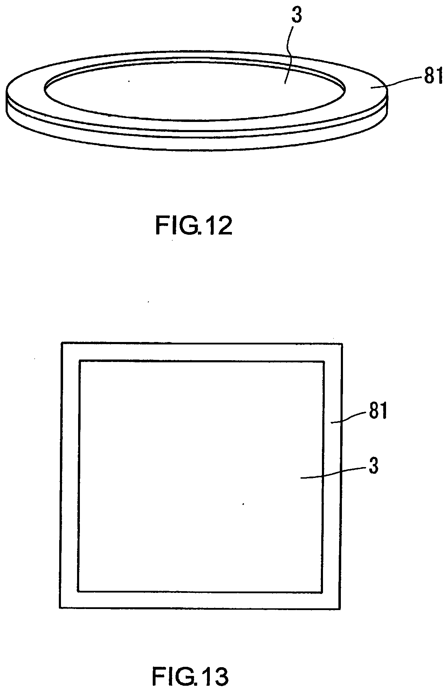

The shape of the supporting member is not limited. For example, as shown in FIG. 12, the supporting member may be a supporting member 81 which is ring-shaped sheet joined to the peripheral portion of the waterproof sound-permeable membrane 3 which is circular as viewed in the direction perpendicular to its principal surfaces. Alternatively, as shown in FIG. 13, the supporting member may be a supporting member 81 which is a frame-shaped sheet joined to the peripheral portion of the waterproof sound-permeable membrane 3 which is rectangular as viewed in the direction perpendicular to its principal surfaces.

Conforming the shape of the supporting member 81 to the shape of the peripheral portion of the waterproof sound-permeable membrane 3 as shown in FIGS. 12 and 13 reduces the deterioration in sound permeability of the waterproof sound-permeable membrane 3 caused by the placement of the supporting member 81. It is preferable for the supporting member 81 to be in the form of a sheet, in terms of improving the handling properties and ease of placement of the waterproof sound-permeable membrane 3.

Examples of the material composing the supporting member 81 include resins, metals, and composites thereof. Examples of the resins include: polyolefins such as polyethylene and polypropylene; polyesters such as PET and polycarbonate; polyimides; and composites of these resins. Examples of the metal include metals having high corrosion resistance such as stainless steel and aluminum.

The thickness of the supporting member 81 is, for example, 5 to 500 µm and preferably 25 to 200 µm. In particular, in view of its function as the portion for attachment, the ring width (frame width: difference between the outer size and inner size) is suitably about 0.5 to 2 mm. A foamed material made of any of the resins mentioned above may be used as the supporting member 81.

The method for joining the waterproof sound-permeable membrane 3 and the supporting member 81 together is not particularly limited. Examples of methods that can be employed include heat welding, ultrasonic welding, bonding by an adhesive, and bonding by a double-sided tape. As previously described, a double-sided tape itself can be used as the supporting member.

In the example shown in FIG. 1, the waterproof sound-permeable membrane 3 is placed on the first space 13-side of the wall 2. In the waterproof sound transmission structure 1, the waterproof sound-permeable membrane 3 may be placed on the second space 12-side of the wall 2. The wall 2 is, for example, a housing of an electronic device, and, in this example, the first space 13 is a space located inside the housing, while the second space 12 is a space located outside the electronic device. The wall 2 is, for example, a housing of an electronic device case, and, in this example, the first space 13 is a space located inside the case enclosing an electronic device, while the second space 12 is a space located outside the electronic device case.

The wall 2 is composed of, for example, a resin, metal, glass, or composite thereof.

In the waterproof sound transmission structure 1, the region (region α in the example shown in FIG. 1) of the waterproof sound-permeable membrane 3 that overlaps an opening of the sound transmission port 11 may have no air-permeable supporting layer 59 so that the resin film 51 and/or liquid-repellent layer 52 is exposed in the region. In this case, the resin film 51 and/or liquid-repellent layer 52 may be exposed only at one principal surface of the waterproof sound-permeable membrane 3 or at both principal surfaces of the membrane 3. This allows the waterproof sound transmission structure 1 to have higher levels of both waterproofness and sound permeability. For example, the waterproof sound-permeable membrane 3 is joined to the wall 2 at the region (region β in the example shown in FIG. 1) of the waterproof sound-permeable membrane 3 that is other than the region overlapping the sound transmission port 11. The joining to the wall 2 may be accomplished via the supporting member 81, and an example of the supporting member 81 is a double-sided tape.

For the waterproof sound transmission structure 1, the insertion loss in the frequency range of 100 Hz to 5 kHz can be, for example, 5 dB or less, 3 dB or less, 2 dB or less, or even 1 dB or less. In addition, the insertion loss in the frequency range of 100 Hz to 3 kHz can be 5 dB or less, 3 dB or less, 2 dB or less, or even 1 dB or less. For the waterproof sound transmission structure 1, the insertion loss at a frequency of 1 kHz, which is considered a median in the frequency range of human voice, can be, for example, 5 dB or less, 3 dB or less, or even 1 dB or less.

The waterproof sound transmission structure 1 can be endowed with good sound permeability, for example, depending on the configuration of the waterproof sound-permeable membrane 3, in particular depending on the diameter and shape of the through holes 53, even when the waterproof sound-permeable membrane 3 has a reduced effective area. For example, the effective area of the waterproof sound-permeable membrane 3 in the waterproof sound transmission structure 1 may be 4.9 mm² or less. The advantageous feature of allowing a reduction in the effective area contributes, for example, to a reduction in the space to be occupied by the waterproof sound transmission structure 1 and to an increase in the flexibility in the visual appearance and design of an electronic device including the structure, in particular a reduction in size and/or thickness of the electronic device. The effective area of the waterproof sound-permeable membrane 3 refers to the area of a portion (effective portion) of the membrane through which, when the membrane is placed to cover a sound transmission port of a housing, sound actually enters, travels in, and exits the membrane. For example, the effective area does not include the area of a supporting member or a joining portion placed or formed on the peripheral portion of the waterproof sound-permeable membrane 3 for placement of the membrane 3. The effective area can typically be equal to the area of the sound transmission port over which the membrane is placed. In the case of a waterproof sound-permeable member including the waterproof sound-permeable membrane and a supporting member placed on the peripheral portion of the membrane, the effective area can be equal to the area of an opening portion of the supporting member.

For the waterproof sound transmission structure 1, the insertion loss as described above can be achieved when the effective area of the waterproof sound-permeable membrane 3 included in the structure 1 is, for example, 4.9 mm² (when the membrane is, for example, in the shape of a circle with a diameter of 2.5 mm). It should be understood that high levels of both waterproofness and sound permeability can be achieved not only when the effective area of the waterproof sound-permeable membrane 3 is small but also when the effective area is large. However, the waterproof sound transmission structure 1 is particularly advantageous when the effective area of the waterproof sound-permeable membrane 3 is or must be small.

When, as shown in FIG. 8, the waterproof sound-permeable membrane 3 is a membrane having the through holes 53 having the cross-section 57 the area of which increases from the first principal surface 54a toward the second principal surface 54b, the sound permeability from the second principal surface 54b at which the dimeter of the through holes 53 is larger is generally better than the sound permeability from the first principal surface 54a at which the diameter is smaller. In this case, the sound permeability from the second principal surface 54b, which is better than that from the first principal surface 54a, can be such that the insertion loss as described above is achieved.

When, as shown in FIG. 8, the waterproof sound-permeable membrane 3 is a membrane having the through holes 53 having the cross-section 57 the area of which increases from the first principal surface 54a toward the second principal surface 54b, the orientation of the waterproof sound-permeable membrane 3 in the waterproof sound transmission structure 1 is not limited. For example, the waterproof sound-permeable membrane 3 may be placed in such a manner that the principal surface 54a (principal surface 54a at which the diameter of the through holes 53 is smaller) of the resin film 51 faces the second space 12. In this case, higher sound permeability from the first space 13 as well as higher waterproofness can be achieved.

The waterproof sound transmission structure 1 can be formed for any sound transmission port 11 of any wall 2 where both waterproofness and sound permeability should be ensured. Products that can include the waterproof sound transmission structure 1 are not limited to particular ones.

The waterproof sound transmission structure 12 can be used in various applications similarly to conventional waterproof sound transmission structures.

### [Electronic device]

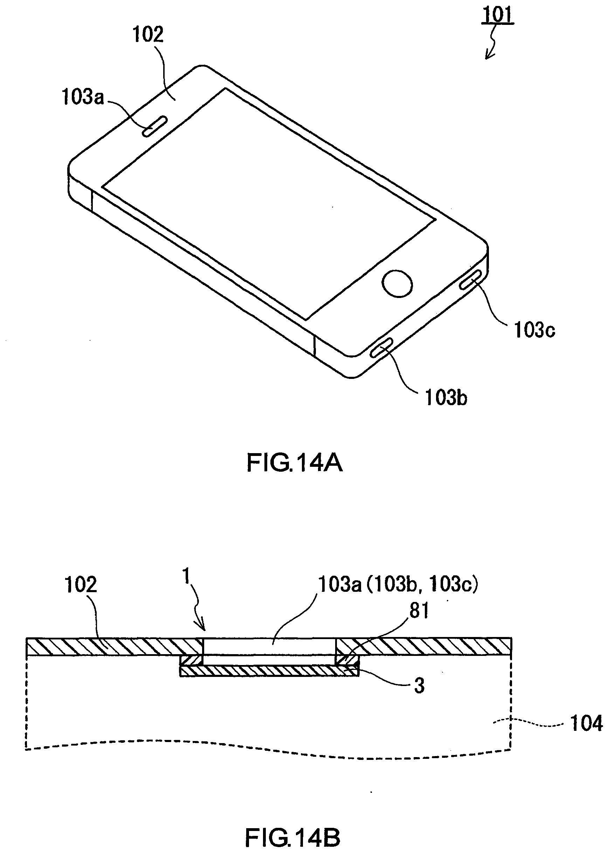

An example of the electronic device of the present invention is shown in FIG. 14A. The electronic device shown in FIG. 14A is a smartphone which is a type of mobile phone. A housing 102 of the smartphone 101 has a sound transmission port 103a provided in proximity to a transducer which is a type of sound emitting-receiving device, a sound transmission port 103b provided in proximity to a microphone which is a type of sound receiver, and a sound transmission port 103c provided in proximity to a speaker which is a type of sound emitter. Sound is transmitted through the sound transmission ports 103a to 103c between the outside of the smartphone 101 and the audio components (transducer, microphone, and speaker) which are placed as audio parts in the housing 102. In the smartphone 101, as shown in FIG. 14B, the waterproof sound-permeable membranes 3 are attached to the inner surface of the housing 102 via the supporting members 81 to cover these sound transmission ports 103a to 103c, so that the waterproof sound transmission structure 1 is formed for each sound transmission port. This makes it possible to prevent water from entering an interior 104 of the housing 102 from the outside of the smartphone 101 through the sound transmission ports while permitting transmission of sound between the outside of the smartphone 101 and the audio parts.

In the waterproof sound transmission structure 1 of the electronic device shown in FIGS. 14A and 14B, the wall 2 is the housing 102 of the smartphone 101, the second space 12 where water can be present is a space located outside the smartphone 101 (or the housing 102) such as a space in which the user of the smartphone 101 lives, the first space 13 is a space located in the interior 104 of the housing 102 of the smartphone 101 and containing the audio parts, and the sound transmission ports 11 are the sound transmission ports 103a to 103c for transmission of sound from and/or to the audio components (audio parts). In the example shown in FIGS. 14A and 14B, the audio part-containing space, namely, the first space 13, is a space located inside the housing 102 of the smartphone 101, and the volumes occupied by components such as the audio components are excluded from the sealed-state volume of the space.

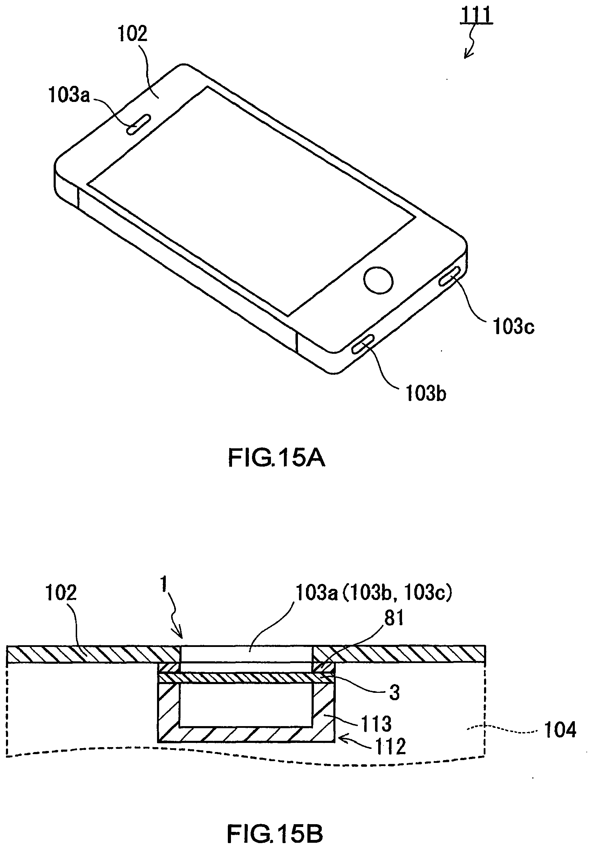

Another example of the electronic device of the present invention is shown in FIGS. 15A and 15B. The electronic device shown in FIGS. 15A and 15B is a smartphone 111, similarly to the electronic device shown in FIGS. 14A and 14B. The smartphone 111 shown in FIGS. 15A and 15B has the same configuration as the smartphone 101 shown in FIGS. 14A and 14B, except that audio components 112 enclosed in the interior 104 of the housing 102 are attached to the sound transmission ports 103a to 103c with the waterproof sound-permeable membranes 3 interposed therebetween. In the waterproof sound transmission structure 1 of the electronic device shown in FIGS. 15A and 15B, the wall 2 is the housing 102 of the smartphone 111, the second space 12 where water can be present is a space located outside the smartphone 111 (or the housing 102), the first space 13 is a space located inside a housing 113 of each of the audio components 112 enclosed in the interior 104 of the housing 102 of the smartphone 111, and the sound transmission ports 11 are the sound transmission ports 103a to 103c for transmission of sound from and/or to audio elements (audio parts) inside the housings 113. In the example shown in FIGS. 15A and 15B, the audio-part containing space, namely, the first space 13, is a space located inside the housing 113 of each audio component 112, and the volumes occupied by audio elements such as a diaphragm placed in the space are excluded from the sealed-state volume of the space.

With the waterproof sound transmission structure 1, high levels of both waterproofness and sound permeability are achieved at sound transmission ports. In the structure 1, even when, for example, the effective area of the waterproof sound-permeable membrane 3 is small, good sound permeability can be obtained depending on the configuration of the membrane 3. The structure 1 also allows an increase in flexibility in design and visual appearance of an electronic device such as a smartphone, in particular a reduction in size and/or thickness of the electronic device.

In the electronic device of the present invention, the location where the waterproof sound transmission structure 1 is formed is not limited as long as sound can be transmitted between the audio part in the electronic device and the outside of the electronic device.

The housing 102 is composed of a resin, metal, glass, or composite thereof. The display portion (such as a surface glass layer of a liquid crystal display) of the electronic device may constitute a part of the housing 102, as in smartphones and tablet computers.

The electronic device of the present invention is not limited to smartphones. Electronic devices that fall under the category of the electronic device of the present invention include all types of electronic devices that are equipped with an audio part, that have a housing provided with a sound transmission port for transmission of sound between the outside of the housing and the audio part, that require prevention of ingress of water into the housing from the outside through the sound transmission port, and that allow the waterproof sound-permeable membrane 3 to be placed to cover the sound transmission port so that the waterproof sound transmission structure 1 is formed. Examples of the electronic device of the present invention include: mobile phones such as feature phones and smartphones; mobile computers such as tablet computers, wearable devices, PDAs, game consoles, and notebook computers; electronic notebooks; digital cameras; video cameras; and electronic book readers.

### [Electronic device case]

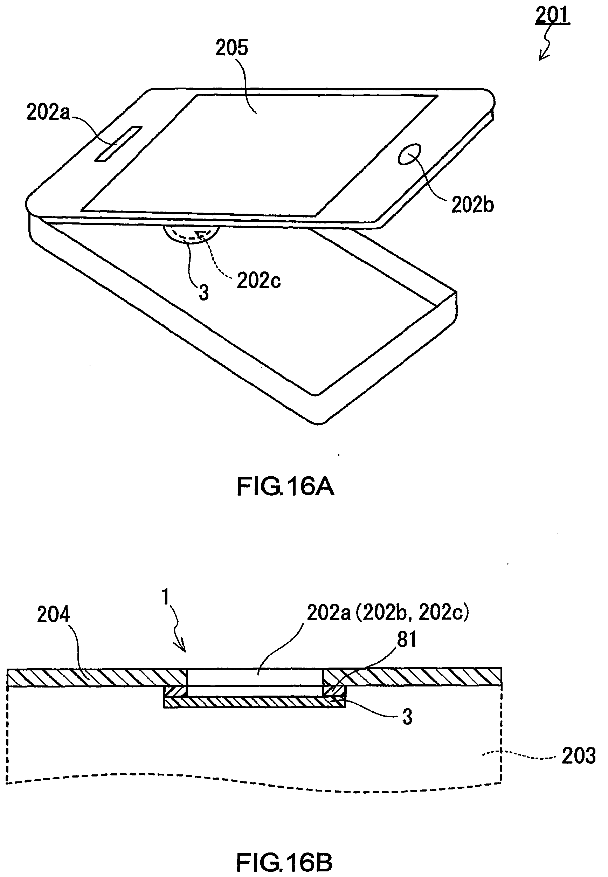

An example of the electronic device case of the present invention is shown in FIG. 16A. The case 201 shown in FIG. 16A is provided with sound transmission ports 202a to 202c for transmission of sound between audio parts of an electronic device enclosed in the case 201 and the outside of the case 201. The case 201 shown in FIG. 16A is a case for a smartphone different in type from the smartphone 101 shown in FIG. 14A. The sound transmission port 202a is provided for transmission of sound to the voice receiver of the smartphone, the sound transmission port 202b is provided for transmission of sound to the voice transmitter of the smartphone, and the sound transmission port 202c is provided for transmission of sound from the speaker of the smartphone to the outside. Sound is transmitted through the sound transmission ports 202a to 202c between the outside of the case 201 and the audio parts of the smartphone enclosed in the case 201. In the case 201, as shown in FIG. 16B, the waterproof sound-permeable membranes 3 are attached to the inner surface of the case 201 via the supporting members 81 to cover the sound transmission ports 202a to 202c so that the waterproof sound transmission structure 1 is formed for each sound transmission port. This makes it possible to prevent water from entering an interior 203 of the case 201, and then the electronic device enclosed in the case 201, from the outside of the case 201 through the sound transmission ports while permitting transmission of sound between the outside of the case 201 and the audio parts.

In the waterproof sound transmission structure 1 of the electronic device case shown in FIGS. 16A and 16B, the wall 2 is the housing 204 of the case 201, the second space 12 where water can be present is a space located outside the case 201 (or the housing 204) such as a space in which the user of the case 201 lives, the first space 13 is a space located in the interior 203 of the case 201 (or of the housing 204) for enclosing the electronic device, and the sound transmission ports 11 are the sound transmission ports 202a to 202c for transmission of sound from and/or to audio parts of the electronic device enclosed in the case 201. In the example shown in FIGS. 16A and 16B, the audio part-containing space, namely, the first space 13, is a space located in the interior 203 of the housing 204 of the case 201 for enclosing an electronic device having audio parts, and the volumes occupied by products which are disposed inside the case 201, such as the electronic device enclosed in the case 201, are excluded from the sealed-state volume of the space. It should be noted that, when air can pass between a space that is inside of the case 201 and outside of the electronic device enclosed in the case 201, and the interior of the housing of the device, the sealed-state volume of the first space 13 includes the volume of a portion of the space inside the housing of the electronic device, the portion communicating with the interior of the case 201. The sealed-state volume of the first space 13 is the volume occupied by air communicable with the waterproof sound-permeable membrane 3 and sound transmission port 11.

The formation of the waterproof sound transmission structure 1 allows high levels of both waterproofness and sound permeability to be achieved at the sound transmission ports. In the structure 1, even when, for example, the effective area of the waterproof sound-permeable membrane 3 is small, good sound permeability can be obtained depending on the configuration of the membrane 3. The structure 1 also enables the electronic device case 201 to be adapted for an electronic device that allows high flexibility in design and visual appearance and that has a reduced size and/or thickness. In addition, the opening 202a (202b, 202c) of the electronic device case 201 can have a small area in the structure 1, which provides an increase in the flexibility in the design and visual appearance of the case 201 itself.

In the electronic device case of the present invention, the location where the waterproof sound transmission structure 1 is formed is not limited, as long as sound can be transmitted between audio parts of the electronic device enclosed in the case and the outside of the case.

The electronic device case 201 is composed of a resin, metal, glass, or composite thereof. The electronic device case 201 can have any configuration, as long as the effects of the present invention are obtained. For example, the case 201 shown in FIG. 16A is a case for a smartphone and includes a film 205 that enables external operation of a touch panel of the smartphone enclosed in the case.

### EXAMPLES

Hereinafter, the present invention will be described in more detail by way of examples. The present invention is not limited to the examples given below.

First, the methods for evaluation of resin films, waterproof sound-permeable membranes, and waterproof sound transmission structures fabricated in Examples and Comparative Examples will be described.

### [Opening diameter of through holes]

The principal surface of each resin film was observed with a scanning electron microscope (SEM), 10 through holes were randomly selected from those captured in the SEM image, and the opening diameters of the selected through holes were determined on the basis of the image. The average of the opening diameters was determined as the opening diameter of the through holes of the resin film.

### [Air permeability]

The through-thickness air permeability of each waterproof sound-permeable membrane was determined according to JIS L 1096 (Method A of air permeability measurement: Frazier method).

### [Water entry pressure]

The water entry pressure of each waterproof sound-permeable membrane was determined according to Method B (high hydraulic pressure method) of water penetration test specified in JIS L 1092. If a test piece of the membrane has an area specified in this standard, the membrane undergoes a significant change in shape. Thus, in order to reduce the change in shape of the membrane to some extent, a stainless steel mesh (opening diameter = 2 mm) was placed on one side of the membrane opposite to its surface subjected to pressure, and in this state the measurement was performed.

### [Whiteness]

The whiteness W of each waterproof sound-permeable membrane was determined by measuring the lightness L, hue a, and chroma b of the principal surface of the waterproof sound-permeable membrane using a color-difference meter (Spectrophotometer SE 6000 manufactured by NIPPON DENSHOKU INDUSTRIES CO., LTD.) complying with JIS L 1015 and then by calculating the whiteness W by the following equation using the measured lightness L, hue a, and chroma b: W = 100 - sqr[(100 - L)² + (a² + b2)].

### [Acoustic properties]

The acoustic properties (including sound pressure loss) of each fabricated waterproof sound-permeable membrane were evaluated as a measure of its sound permeability. The evaluation method was as follows.

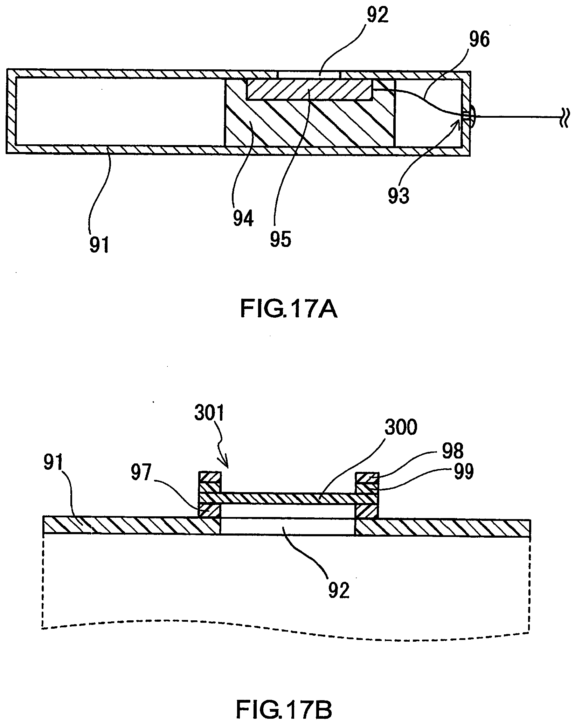

First, as shown in FIG. 17A, a simulated housing 91 (made of polystyrene and having outer dimensions of 60 mm × 50 mm × 28 mm) imitating a housing of a mobile phone was prepared. The simulated housing 91 was provided with: one speaker attachment hole 92 (having the shape of a circle of 2.5 mm diameter) serving as a sound transmission port for allowing sound output from a speaker to be transmitted to the outside of the housing; and one guide hole 93 for a speaker cable. The housing had no openings other than these holes. Next, a speaker 95 (SCG-16A, manufactured by STAR MICRONICS CO., LTD) was embedded in a filler 94 made of urethane sponge and having formed therein a sound transmission port having the shape of a circle of 5 mm diameter, and the filler 94 with the speaker 95 was placed inside the housing 91. The speaker cable 96 of the speaker 95 was led to the outside of the housing 91 through the guide hole 93, and then the guide hole 93 was filled with putty.

Next, a double-sided tape 97 (manufactured by NITTO DENKO CORPORATION, identified as No. 57120B, and having a thickness of 0.2 mm) made of a polyethylene foam, a PET film 98 (having a thickness of 0.1 mm), and a double-sided tape 99 (manufactured by NITTO DENKO CORPORATION, identified as No. 5603, and having a thickness of 0.03 mm) made of PET were prepared. A ring-shaped piece having an inner diameter of 2.5 mm and an outer diameter of 5.8 mm was punched from each of the prepared tapes and film. Additionally, circular pieces having a diameter of 5.8 mm were punched from waterproof sound-permeable membranes 300 fabricated in Examples and Comparative Examples. Next, the ring-shaped piece of the double-sided tape 97 having an inner diameter of 2.5 mm, the circular piece of the waterproof sound-permeable membrane 300, the ring-shaped piece of the double-sided tape 99 having an inner diameter of 2.5 mm, and the ring-shaped piece of the PET film 98 having an inner diameter of 2.5 mm were stacked in this order in such a manner that their entire outer peripheries exactly overlapped each other. Thus, a waterproof sound-permeable member A (in which the waterproof sound-permeable membrane had an effective area of 4.9 mm²) for acoustic property evaluation was prepared (see FIG. 17B).

Next, the waterproof sound-permeable member prepared was attached to the exterior of the simulated housing 91 by means of the polyethylene foam double-sided tape 97 of the member so that the waterproof sound-permeable membrane 300 fully covered the sound transmission port 92 and that a waterproof sound transmission structure 301 was formed. This was done in such a manner that no gap was formed between the waterproof sound-permeable membrane 300 and the double-sided tape 97 and between the double-sided tape 97 and the simulated housing 91.

Next, the speaker cable 96 and a microphone (Spm0405Hd4H-W8 manufactured by Knowles Acoustic) were connected to an acoustic evaluation system (Multi-analyzer System 3560-B-030 manufactured by B&K Sound & Vibration Measurement A/S), and the microphone was placed at a distance of 21 mm from the sound transmission port 92 of the simulated housing 91. Then, SSR analysis (test signals of 20 Hz to 10 kHz, sweep) was selected as an evaluation mode and carried out to evaluate the acoustic properties (THD and sound pressure loss) of the waterproof sound-permeable membrane 300. The sound pressure loss was automatically determined on the basis of the signal input to the speaker 95 from the acoustic evaluation system and the signal detected through the microphone. Additionally, a blank sound pressure loss was determined in the same manner except for the absence of the waterproof sound-permeable membrane, and a value obtained by subtracting the blank sound pressure loss from the sound pressure loss determined in the presence of the waterproof sound-permeable membrane was determined as the sound pressure loss (insertion loss) to be used as a measure of the sound permeability of the waterproof sound-permeable membrane. A smaller insertion loss can be considered to indicate better maintenance of the properties of sound transmitted through the waterproof sound-permeable membrane. This evaluation was carried out on the waterproof sound-permeable membranes fabricated in Examples and Comparative Examples. Table 1 given below shows values of insertion loss at a frequency of 5 kHz. In general, the insertion loss caused by a waterproof sound-permeable membrane increases with increasing frequency in the frequency range of 20 Hz to 10 kHz. Thus, the insertion loss at a frequency of 5 kHz corresponds to the maximum value of the insertion loss in the frequency range of 10 Hz to 5 kHz.

### [Waterproof sound transmission structure]

Waterproof sound transmission structures were formed using the fabricated waterproof sound-permeable membranes. Whether each structure was compliant with IPX7 which is a degree of protection against water ingress was evaluated for different values of the sealed-state volume of the first space. The evaluation method was as follows.

### (Sealed-state volume of first space: 300 mm³ or more)

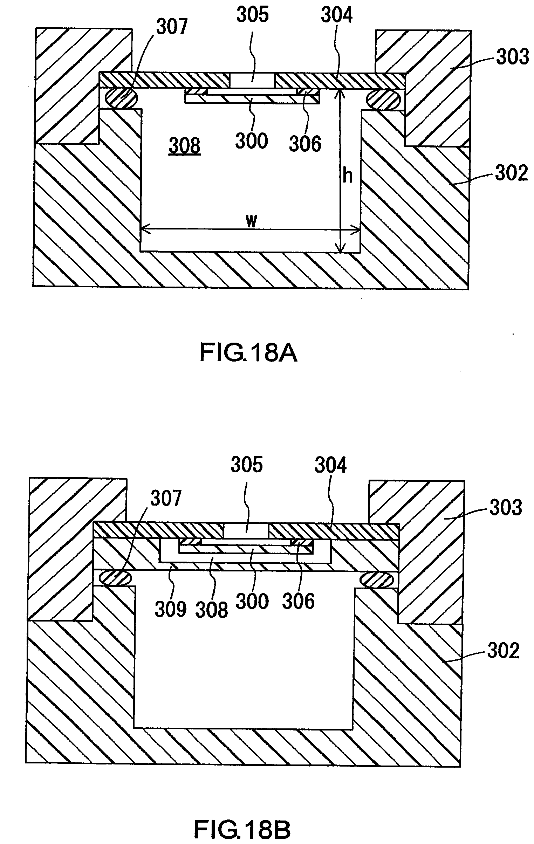

As shown in FIG. 18A, each of the waterproof sound-permeable membranes 300 fabricated in Examples and Comparative Examples was set in jigs 302 and 303 for IPX7 testing. Specifically, the waterproof sound-permeable membrane 300 was attached, using a ring-shaped double-sided tape 306, to a polycarbonate plate 304 provided with an opening 305 of 2.0 mm diameter so as to cover the opening. After that, the plate 304 with the the membrane 300 was fixed by means of the jigs 302 and 303 and an O-ring 307. The diameter of the opening of the double-sided tape 306 was 2.5 mm, which means that the effective area of the waterproof sound-permeable membrane 300 was 4.9 mm². The space 308 bounded by the jig 302, plate 304, O-ring 307, and waterproof sound-permeable membrane 300 corresponds to the first space 13. The volume of the space was varied using various jigs 302 differing in height h and width w, and whether the waterproof sound transmission structure including the waterproof sound-permeable membrane 300 was compliant with IPX7 was evaluated using the same membrane 300 for different values of the sealed-sate volume of the space 308. This evaluation was conducted by immersing the waterproof sound transmission structure in water at a depth of 1 m for 30 minutes according to JIS C 0920. When this immersion causes no ingress of water into the space 308, the waterproof sound transmission structure is determined to be compliant with IPX7. The water pressure acting on the waterproof sound-permeable membrane 300 during evaluation was 9.8 kPa since the water immersion depth was 1 m.

### (Sealed-state volume of first space: less than 300 mm³)

As shown in FIG. 18B, each of the waterproof sound-permeable membranes 300 fabricated in Examples and Comparative Examples was set in jigs 302 and 303 for IPX7 testing. The waterproof sound-permeable membrane 300 was attached, using a ring-shaped double-sided tape 306, to a polycarbonate plate 304 provided with an opening 305 of 2.0 mm diameter so as to cover the opening. Then, unlike the case where the sealed-state volume of the second space was 300 mm³ or more (FIG. 18A), a polycarbonate plate 309 having a given recess (typically a groove) in its one principal surface was joined to that surface of the plate 304 to which the waterproof sound-permeable membrane 300 was attached. This joining was done so that the waterproof sound-permeable membrane 300 was placed inside the recess. The pair of plates 304 and 309 enclosing the waterproof sound-permeable membrane 300 was fixed by means of the jigs 302 and 303 and an O-ring 307. The diameter of the opening of the double-sided tape 306 was 2.5 mm, which means that the effective area of the waterproof sound-permeable membrane 300 was 4.9 mm². The space 308 bounded by the plates 304 and 309 and the waterproof sound-permeable membrane 300 corresponds to the first space 13. The volume of the space was varied by changing the size of the recess of the plate 309, and whether the waterproof sound transmission structure including the waterproof sound-permeable membrane 300 was compliant with IPX7 was evaluated using the same membrane 300 for different values of the sealed-sate volume of the space 308. This evaluation was conducted by immersing the waterproof sound transmission structure in water at a depth of 1 m for 30 minutes according to JIS C 0920. When this immersion causes no ingress of water into the space 308, the waterproof sound transmission structure is determined to be compliant with IPX7.

### (Example 1)

There was prepared a commercially-available non-porous PET film (Track etched membrane manufactured by it4ip S.A. and having a thickness of 50 µm) having through holes formed to extend through the thickness of the film. The diameter of the through holes of the film was 10.6 µm, and the hole density of the film was 3.0 × 10⁵ holes/cm².

Next, the PET film prepared was immersed in an etchant (an aqueous solution of 20 mass% potassium hydroxide) maintained at 80°C for 30 minutes. After the etching, the film was taken out of the etchant, immersed and washed in RO water (water filtered through a reverse osmosis membrane), and then dried by a drying oven set at 50°C. Thus, a non-porous resin film having through holes formed to extend through the thickness of the film was obtained. The diameter of the through holes of the resin film obtained was 13.0 µm, and the area of a cross-section of each through hole taken perpendicular to the direction of the central axis of the hole was constant in the thickness direction of the film. The hole density remained unchanged before and after the etching.

Next, the resin film thus obtained was immersed in a liquid-repellent treatment solution for 3 seconds and then left to dry at ordinary temperature for 30 minutes to form a liquid-repellent layer on the surfaces of the film and on the inner peripheral surfaces of the through holes, thus obtaining a waterproof sound-permeable membrane. The liquid-repellent treatment solution was prepared by diluting a liquid-repellent agent (X-70-029C, manufactured by Shin-Etsu Chemical Co., Ltd.) with a diluent (FS thinner, manufactured by Shin-Etsu Chemical Co., Ltd.) to a concentration of 0.7 wt%.

The properties of the waterproof sound-permeable membrane thus obtained and the waterproof sound transmission structure formed using this membrane are shown in Table 1 below.

### (Example 2)

A waterproof sound-permeable membrane was obtained in the same manner as in Example 1, except that the duration of immersion of the prepared PET film in the etchant was changed to 20 minutes. Changing the duration of immersion in the etchant causes a change in the diameter of through holes of the resulting resin film.

The properties of the waterproof sound-permeable membrane thus obtained and the waterproof sound transmission structure formed using this membrane are shown in Table 1 below.

### (Example 3)

A waterproof sound-permeable membrane was obtained in the same manner as in Example 1, except that the prepared PET film was not etched. The properties of the waterproof sound-permeable membrane thus obtained and the waterproof sound transmission structure formed using this membrane are shown in Table 1 below.

### (Example 4)

There was prepared a commercially-available non-porous PET film (Track etched membrane manufactured by it4ip S.A. and having a thickness of 45 µm) having through holes formed to extend through the thickness of the film. The diameter of the through holes of the film was 3.0 µm, and the hole density of the film was 2.0 × 10⁶ holes/cm².

Next, the PET film prepared was immersed in an etchant (an aqueous solution of 20 mass% potassium hydroxide) maintained at 80°C for 30 minutes. After the etching, the film was taken out of the etchant, immersed and washed in RO water (water filtered through a reverse osmosis membrane), and then dried by a drying oven set at 50°C. Thus, a non-porous resin film having through holes formed to extend through the thickness of the film was obtained. The diameter of the through holes of the resin film obtained was 5.9 µm, and the area of a cross-section of each through hole taken perpendicular to the direction of the central axis of the hole was constant in the thickness direction of the film. The hole density remained unchanged before and after the etching.

Next, the dried resin film was dyed with a disperse dye. The dyed film was black when viewed with the naked eye.

Next, the black film thus fabricated was immersed in a liquid-repellent treatment solution identical to that used in Example 1 for 3 seconds, and then left to dry at ordinary temperature for 30 minutes to form a liquid-repellent layer on the surfaces of the film and on the inner peripheral surfaces of the through holes, thus obtaining a waterproof sound-permeable membrane.

The properties of the waterproof sound-permeable membrane thus obtained and the waterproof sound transmission structure formed using this membrane are shown in Table 1 below.

### (Comparative Example 1)

A waterproof sound-permeable membrane was obtained in the same manner as in Example 1, except that the duration of immersion of the prepared PET film in the etchant was changed to 40 minutes. The properties of the waterproof sound-permeable membrane thus obtained and the waterproof sound transmission structure formed using this membrane are shown in Table 1 below.

### (Comparative Example 2)

A waterproof sound-permeable membrane was obtained in the same manner as in Example 4, except that the duration of immersion of the prepared PET film in the etchant was changed to 20 minutes. The properties of the waterproof sound-permeable membrane thus obtained and the waterproof sound transmission structure formed using this membrane are shown in Table 1 below.

### (Comparative Example 3)

A waterproof sound-permeable membrane was obtained in the same manner as in Example 4, except that the prepared PET film was neither etched nor dyed with the disperse dye. The properties of the waterproof sound-permeable membrane thus obtained and the waterproof sound transmission structure formed using this membrane are shown in Table 1 below.

### (Comparative Example 4)

A waterproof sound-permeable membrane was obtained in the same manner as in Example 2, except that the prepared PET film was a different commercially-available non-porous PET film (Track etched membrane manufactured by it4ip S.A. and having a thickness of 30 µm) having through holes formed to extend through the thickness of the film. The properties of the waterproof sound-permeable membrane thus obtained and the waterproof sound transmission structure formed using this membrane are shown in Table 1 below. The diameter of the through holes of the prepared PET film was 1.0 µm, and the hole density of the film was 3.0 × 10⁷ holes/cm².

### (Comparative Example 5)

A waterproof sound-permeable membrane was obtained in the same manner as in Comparative Example 4, except that the prepared PET film was not etched. The properties of the waterproof sound-permeable membrane thus obtained and the waterproof sound transmission structure formed using this membrane are shown in Table 1 below.

### (Comparative Example 6)

There was prepared a commercially-available mesh film (Smartmesh-P 180/460-27, manufactured by Nippon Tokushu Fabric Inc. and having a thickness of 43 µm). The diameter of the openings of the film was 40 µm. The mesh prepared was subjected to a liquid-repellent treatment identical to that in Example 1, and thus a waterproof sound-permeable membrane was obtained. The properties of the waterproof sound-permeable membrane thus obtained and the waterproof sound transmission structure formed using this membrane are shown in Table 1 below.

**[Table 1]**

| | | Comparative Example 1 | Example 1 | Example 2 | Example 3 | Example 4 | Comparative Example 2 | Comparative Example 3 | Comparative Example 4 | Comparative Example 5 | Comparative Example 6 |
|---|---|---|---|---|---|---|---|---|---|---|---|
| Whiteness W | | - | 60 | - | - | 12 | 41 | - | - | - | - |
| Water entry pressure (kPa) | | 1.9 | 2.4 | 4.0 | 6.5 | 8.5 | 13.8 | 27.0 | 40.0 | 70.0 | 6.0 |
| Through hole diameter (µm) | | 15.0 | 13.0 | 12.0 | 10.6 | 5.9 | 4.5 | 3.0 | 2.1 | 1.0 | 28.0 |
| Air permeability (cm³/(cm² · sec)) | | 195.3 | 119.7 | 92.4 | 63.5 | 11.8 | 9.64 | 2.90 | 0.97 | 0.77 | - |
| Insertion loss (dB at 5 kHz) | | 0.0 | 0.2 | 0.1 | 0.2 | 1.7 | 4.6 | 6.7 | 10.4 | 13.8 | 17.8 |
| IPX7 testing / Volume of first space (mm³) | 5 | Poor | Good | Good | Good | Good | Good | Good | Good | Good | Good |
| | 10 | - | Poor | Good | Good | Good | Good | Good | Good | Good | Good |
| | 40 | - | - | Poor | Good | Good | Good | Good | Good | Good | Good |
| | 80 | - | - | - | Good | Good | Good | Good | Good | Good | Poor |
| | 200 | - | - | - | Good | Good | Good | Good | Good | Good | - |
| | 300 | - | - | - | Poor | Good | Good | Good | Good | Good | - |
| | 500 | - | - | - | - | Poor | Good | Good | Good | Good | - |
| | 1000 | - | - | - | - | - | Good | Good | Good | Good | - |
| | 1500 | - | - | - | - | - | Good | Good | Good | Good | - |
| | 4000 | - | - | - | - | - | Good | Good | Good | Good | - |
| | 5000 | - | - | - | - | - | Good | Good | Good | Good | - |

| | | | | | | | | | | | |
|---|---|---|---|---|---|---|---|---|---|---|---|
| * "-" means being unmeasured. "Good" means being compliant with IPX7. "Poor" means not being compliant with IPX7. * The through hole diameter shown for Comparative Example 6 is the diameter (pm) of the mesh openings. | | | | | | | | | | | |

As seen from Table 1, the waterproof sound transmission structures of Examples 1 to 4, each of which employed a waterproof sound-permeable membrane including a non-porous resin film having through holes extending through the thickness of the resin film and having a diameter of 5.0 µm or more and 13.0 µm or less, were compliant with IPX7 when the volume of the first space (space 308) was equal to or smaller than a given value, despite the fact that the inherent water entry pressure of the waterproof sound-permeable membrane used in each structure was lower than 9.8 kPa corresponding to a water pressure acting on the membrane during the IPX7 testing. The volume of the second space was 5 mm³ or less in Example 1 where the inherent water entry pressure of the waterproof sound-permeable membrane was 2.4 kPa, 10 mm³ or less in Example 2 where the inherent water entry pressure was 4.0 kPa, 200 mm³ or less in Example 3 where the inherent water entry pressure was 6.5 kPa, and 300 mm³ or less in Example 4 where the inherent water entry pressure was 8.5 kPa.

By contrast, the waterproof sound transmission structure of Comparative Example 1, which employed a waterproof sound-permeable membrane including a non-porous resin film having through holes extending through the thickness of the resin film and having a diameter of 15.0 µm, failed to be compliant with IPX7 even when the volume of the first space was 5 mm³. The waterproof sound transmission structures of Comparative Examples 2 to 5, each of which employed a waterproof sound-permeable membrane including a non-porous resin film having through holes extending through the thickness of the resin film and having a diameter of less than 5.0 µm, was compliant with IPX7 regardless of the volume of the first space; however, it should be noted that the inherent water entry pressure of these waterproof sound-permeable membranes was more than 9.8 kPa. The waterproof sound-permeable membranes of Comparative Examples 2 to 5 caused a much greater insertion loss than those of Examples 1 to 4. In Comparative Example 6 where a waterproof sound-permeable membrane having a mesh structure was used, the insertion loss was considerably great, namely 17.8 dB.

The present invention may be embodied in other forms without departing from the spirit or essential characteristics thereof. The embodiments disclosed in this specification are to be considered in all respects as illustrative and not limiting. The scope of the present invention is indicated by the appended claims rather than by the foregoing description, and all changes which come within the meaning and range of equivalency of the claims are intended to be embraced therein.

### INDUSTRIAL APPLICABILITY

The waterproof sound transmission structure of the present invention is applicable to any product required to prevent penetration of water while maintaining sound permeability.

## Claims

1. A waterproof sound transmission structure comprising:
a wall separating a first space from a second space where water can be present, the wall being provided with a sound transmission port for transmission of sound between the first and second spaces; and
a waterproof sound-permeable membrane placed to cover the sound transmission port, the waterproof sound-permeable membrane being adapted to permit transmission of sound between the first and second spaces and being further adapted to prevent ingress of water from the second space into the first space through the sound transmission port, wherein
the first space is sealed when the second space is filled with water, the sealed first space having a volume of 300 mm³ or less, and
the waterproof sound-permeable membrane comprises:
a non-porous resin film having through holes formed to extend through the thickness of the resin film; and
a liquid-repellent layer formed on a principal surface of the resin film and having openings positioned in correspondence with the through holes,
the through holes having a diameter of 5.0 µm or more and 13.0 µm or less.

2. The waterproof sound transmission structure according to claim 1, wherein a water entry pressure of the waterproof sound transmission structure is greater than a water entry pressure of the waterproof sound-permeable membrane placed to cover the sound transmission port, the water entry pressure of the waterproof sound-permeable membrane being measured according to Method B (high hydraulic pressure method) of water penetration test specified in JIS L 1092.

3. The waterproof sound transmission structure according to claim 1, being compliant with IPX7 specified as a degree of protection against water ingress in JIS C 0920.

4. The waterproof sound transmission structure according to claim 3, wherein
the water entry pressure of the waterproof sound-permeable membrane is 3.0 kPa or more and less than 9.8 kPa, and
the volume is 10 mm³ or less.

5. The waterproof sound transmission structure according to claim 3, wherein
the water entry pressure of the waterproof sound-permeable membrane is 2.0 kPa or more and less than 3.0 kPa, and
the volume is 5 mm³ or less.

6. The waterproof sound transmission structure according to claim 1, wherein an effective area of the waterproof sound-permeable membrane is 4.9 mm² or less.

7. The waterproof sound transmission structure according to claim 1, wherein the waterproof sound-permeable membrane has an air permeability in a thickness direction of the waterproof sound-permeable membrane, the air permeability being 2.0 cm³/(cm² • sec) or more and 120 cm³/(cm² • sec) or less as expressed in terms of Frazier number measured according to JIS L 1096.

8. The waterproof sound transmission structure according to claim 1, wherein an insertion loss in a frequency range of 100 Hz to 5 kHz is 2 dB or less.

9. The waterproof sound transmission structure according to claim 1, wherein the waterproof sound-permeable membrane is subjected to a coloring treatment that enables the waterproof sound-permeable membrane to absorb light in a wavelength range of 380 nm to 500 nm.

10. The waterproof sound transmission structure according to claim 1, wherein the waterproof sound-permeable membrane is colored black, gray, brown, or pink.

11. An electronic device having an audio part, the electronic device comprising the waterproof sound transmission structure according to any one of claims 1 to 10, wherein
in the waterproof sound transmission structure,
the wall is a housing of the electronic device,
the second space is a space located outside the housing,
the first space is a space located inside the housing and containing the audio part, and
the sound transmission port is a sound transmission port for transmission of sound from and/or to the audio part.

12. An electronic device case for enclosing an electronic device having an audio part, the electronic device case comprising the waterproof sound transmission structure according to any one of claims 1 to 10, wherein
in the waterproof sound transmission structure,
the wall is a housing of the case,
the second space is a space located outside the housing,
the first space is a space located inside the housing for enclosing the electronic device, and
the sound transmission port is a sound transmission port for transmission of sound from and/or to the audio part of the electronic device enclosed in the case.
